# EUROPEAN PATENT SPECIFICATION

(11) **EP 4 471 102 B1**
(45) Date of publication and mention of the grant of the patent: **16.09.2026**
(21) Application number: 23770540.5
(22) Date of filing: 07.03.2023
(51) Int. Cl.: C09J 123/08, C03C 27/12, C09J 131/06, C09J 133/14, B32B 7/12, B32B 17/10, B32B 27/28, B32B 27/36, H10F 19/80

(54) **ADHESIVE RESIN COMPOSITION, LAMINATED GLASS INTERLAYER, LAMINATED GLASS, SOLAR CELL ENCAPSULANT, AND SOLAR CELL MODULE**
KLEBEHARZZUSAMMENSETZUNG, VERBUNDGLASZWISCHENSCHICHT, VERBUNDGLAS, SOLARZELLENVERKAPSELUNGSSTOFF UND SOLARZELLENMODUL
COMPOSITION DE RÉSINE ADHÉSIVE, COUCHE INTERMÉDIAIRE DE VERRE FEUILLETÉ, VERRE FEUILLETÉ, ENCAPSULANT DE CELLULE PHOTOVOLTAÏQUE ET MODULE DE CELLULE PHOTOVOLTAÏQUE

(30) Priority: 15.03.2022 JP 2022040794
(43) Date of publication of application: 04.12.2024
(73) Proprietor: Dow-Mitsui Polychemicals Co., Ltd., Tokyo 104-0028 (JP)
(72) Inventor: SHIMIZU Takahiro, Ichihara-shi, Chiba 299-0108 (JP); OOGI Kazuyuki, Ichihara-shi, Chiba 299-0108 (JP); YAMAMOTO Sadaki, Ichihara-shi, Chiba 299-0108 (JP)
(74) Representative: Gulde & Partner
(86) International application number: PCT/JP2023/008531
(87) International publication number: WO 2023/176584

(56) References cited:
- WO-A1-2010/090212
- WO-A1-2015/125595
- WO-A1-2017/057216
- JP-A- 2009 298 046
- JP-A- 2011 511 875
- JP-A- 2013 501 102
- JP-A- 2017 123 434
- JP-A- 2019 073 408
- US-A1- 2009 214 863
- "Functional polyolefin", Retrieved from the Internet <URL:http://www.tokyozairyo.co.jp/chn/products/plastics/polyolefin.html> [retrieved on 20230426]

## Description

### TECHNICAL FIELD

The present invention relates to a laminated glass interlayer comprising an adhesive layer including an adhesive resin composition, a laminated glass, a solar cell encapsulant, and a solar cell module.

### BACKGROUND ART

The laminated glass interlayer is provided between two glasses. The laminated glass interlayer can prevent scattering of fragments when the glass is damaged, and can prevent the glass from collapsing due to self-supporting properties of the interlayer when the glass is broken. Thus, the laminated glass interlayer is preferably used from the viewpoint of safety.

As a material of the laminated glass interlayer having high transparency, for example, an ionomer resin is used. The ionomer resin is characterized in that it has excellent transparency and excellent adhesiveness to glass.

For example, JP 2013-28486 A describes an interlayer for laminated glass in which a two-component copolymer of (A) ethylene and (B) (meth)acrylic acid or (meth)acrylic acid acryl ester is crosslinked with metal ions, and the interlayer consists of an ionomer resin in which an MFR at 190°C × 2.16 Kgf is 5 to 15 g/10 min. In addition, JP 2013-28486 A describes the interlayer for laminated glass in which, although a humidity control step (moisture conditioning step) is unnecessary and a bonding process with a glass plate is simple, sufficient adhesiveness with a glass plate and excellent followability to a glass plate can be obtained, excellent toughness in a wide temperature range can be maintained, discoloration with respect to direct sunlight or ultraviolet light is not likely to occur, and excellent weather resistance and transparency can be simultaneously obtained.

In addition, JP 2009-512763 A describes a polymer sheet having a thickness of 10 mils (0.25 mm) or greater and including at least one layer that includes an ionomer or an ionomer blend into which partially neutralized α, β-ethylenically unsaturated carboxylic acid is introduced. The ionomer or ionomer blend includes ions of one or more monovalent metals in an amount ranging from about 1 to about 60% and ions of one or more polyvalent metals in an amount ranging from about 40 to about 99% with respect to a total amount of neutralization of the α, β-ethylenically unsaturated carboxylic acid. In addition, JP 2009-512763 A describes that this polymer sheet exhibits a synergistically high adhesive force to glass.

In addition, JP 2012-519646 A discloses a glass laminate including a thin glass sheet and an ionomer interlayer sheet, in which the thin glass sheet has a thickness of 1.5 mm or less.
JP 2012-519646 A describes that, in the glass laminate, the weight is light, and advantageous performance characteristics such as excellent impact adhesion level, excellent moisture resistance, and low stress can be maintained.

JP 2011-511875 A discloses a binder based on an ethylene/carboxylic acid vinyl ester copolymer and a polyolefin. The binder has good adhesive properties for adhering to supports, including glass, metal, polymers such as PMMA, EVA, PE or PP, and crystalline silicon. The binder can be used in encapsulating materials for solar cells. Specifically disclosed multilayer structures are LD-PE/binder/glass, LD-PE/binder/PMMA, PVDF/PET/PVDF/binder/glass and PVDF/PET/PVDF/binder/PMMA.

WO 2015/125595 A1 discloses a resin film used as an interlayer film for a laminated glass or as a sealing material for a solar cell module, which is excellent in adhesion to glass and PET and in ultraviolet shielding property, and which is suppressed in yellowing. The resin film comprises a copolymer composed of a structural unit derived from ethylene, a structural unit based on (meth)acrylate ester, and a structural unit based on a monomer having a glycidyl group. Specifically disclosed multilayer structures are glass/interlayer/PET/interlayer/glass and glass/interlayer/glass, and glass/interlayer/solar cell/interlayer/backsheet.

WO 2010/090212 A1 discloses a laminated glass including an interlayer film disposed between a glass plate and a polyethylene terephthalate film, i.e. the structure glass/interlayer/PET.

JP 2013-501102 A discloses a cross-linked encapsulant for solar cell modules, essentially consisting of a blend of two ethylene copolymers.

### SUMMARY OF THE INVENTION

### TECHNICAL PROBLEM

Recently, there has been an increasing demand for providing a polyester resin layer having a decoration between the glass and the laminated glass interlayer in order to impart design properties to the laminated glass having high transparency. However, the ionomer has excellent glass adhesiveness but has poor adhesiveness to a polyester resin. Therefore, it may be difficult to directly laminate a layer including the ionomer (hereinafter, also referred to as "ionomer resin layer") and a polyester resin layer including a polyester resin (hereinafter, also referred to as "polyester resin layer") .

As one method for laminating the ionomer resin layer and the polyester resin layer, for example, a method of laminating a layer including an adhesive resin composition between the ionomer resin layer and the polyester resin layer can be used. However, the adhesive resin composition having high adhesiveness to the polyester resin layer has insufficient transparency, and when the layer including the adhesive resin composition is laminated between the ionomer resin layer and the polyester resin layer, the transparency of the laminated glass may decrease.

In addition, since the glass or the polyester resin layer is also used for a solar cell module, there are cases where improvement of transparency and adhesiveness to a polyester resin layer may also be required for a solar cell encapsulant for encapsulating a solar cell element in the solar cell module.

That is, an adhesive resin composition having improved transparency and adhesiveness to a polyester resin layer is desired.

The present invention has been made in view of the above circumstances, and an object of the present invention is to provide an adhesive resin composition having improved transparency and adhesiveness to a polyester resin layer, a laminated glass interlayer having improved transparency, adhesiveness to a polyester resin layer, and adhesiveness to glass, laminated glass, a solar cell encapsulant, and a solar cell module.

### SOLUTION TO PROBLEM

According to the present invention, a laminated glass interlayer, a laminated glass, a solar cell encapsulant, and a solar cell module shown below are provided as defined in the independent claims.

The laminated glass interlayer according to the invention comprises, in the following order: an ionomer resin layer that includes an ionomer (C) of an ethylene-unsaturated carboxylic acid-based copolymer; an adhesive resin layer that includes an adhesive resin composition; and a polyester resin layer that includes a polyester resin (D). The adhesive resin composition including:
an ethylene-unsaturated ester copolymer (A); and
an epoxy group-containing ethylene-based copolymer (B) (other than the ethylene-unsaturated ester copolymer (A)),
in which a content of a constituent unit derived from an unsaturated ester in the ethylene-unsaturated ester copolymer (A) is more than 20 mass% with respect to all constituent units forming the ethylene-unsaturated ester copolymer (A), and
an absolute value of a difference (X₁ - X₂) between a content (X₁) of a constituent unit derived from ethylene with respect to all the constituent units forming the ethylene-unsaturated ester copolymer (A) and a content (X₂) of a constituent unit derived from ethylene with respect to all constituent units forming the epoxy group-containing ethylene-based copolymer (B) is 10 mass% or less.

According to an embodiment of the laminated glass interlayer, a melt flow rate of the ethylene-unsaturated ester copolymer (A) measured according to JIS K 7210:1999 under conditions of 190°C and a load of 2160 g is 1 g/10 min or more and 100 g/10 min or less.

According to an embodiment of the laminated glass interlayer, the ethylene-unsaturated ester copolymer (A) includes an ethylene-vinyl acetate copolymer.

According to an embodiment of the laminated glass interlayer, the epoxy group-containing ethylene-based copolymer (B) includes at least one kind selected from the group consisting of an ethylene-glycidyl (meth)acrylate copolymer, an ethylene-glycidyl (meth)acrylate-vinyl acetate copolymer, and an ethylene-glycidyl (meth)acrylate-(meth)acrylic acid ester copolymer.

According to an embodiment of the laminated glass interlayer, the content of the constituent unit derived from ethylene in the epoxy group-containing ethylene-based copolymer (B) is 82 mass% or less with respect to all the constituent units forming the epoxy group-containing ethylene-based copolymer (B).

According to an embodiment of the laminated glass interlayer, a Vicat softening point of the epoxy group-containing ethylene-based copolymer (B) defined according to JIS K 7206:1999 is 65°C or lower.

According to an embodiment of the laminated glass interlayer, a melting point of the epoxy group-containing ethylene-based copolymer (B) measured according to JIS K 7121:1987 is 90°C or lower.

According to an embodiment of the laminated glass interlayer, a haze measured using the following method is 10% or less,

(Method)
the adhesive resin composition is pressed under conditions of 140°C and 9.8 MPa and is subsequently cooled under conditions of 20°C and 14.7 MPa to prepare a press sheet having a thickness of 3 mm, and subsequently a haze of the obtained press sheet is measured by a haze meter according to JIS K 7136:2000.

According to an embodiment of the laminated glass interlayer, when a total content of the ethylene-unsaturated ester copolymer (A) and the epoxy group-containing ethylene-based copolymer (B) is represented by 100 mass%, a content of the ethylene-unsaturated ester copolymer (A) is 40 mass% or more and 99 mass% or less.

According to an embodiment of the laminated glass interlayer, when a total content of the adhesive resin composition is represented by 100 mass%, a total content of the ethylene-unsaturated ester copolymer (A) and the epoxy group-containing ethylene-based copolymer (B) is 70 mass% or more and 100 mass% or less.

According to an embodiment of the laminated glass interlayer, a haze measured using the following method is 5% or less,

(Method)
glass having a thickness of 3.2 mm, an ionomer resin layer having a thickness of 1500 µm, a sheet having a thickness of 100 µm and formed of the adhesive resin composition, and glass having a thickness of 3.2 mm are laminated in this order and are bonded at a heating temperature of 140°C and a pressure of 1 atm during heating for a heating time of 20 minutes, the obtained laminate is slowly cooled by natural cooling to prepare a glass laminate for optical characteristics evaluation, and subsequently a haze of the obtained glass laminate is measured by a haze meter according to JIS K 7136:2000.

According to an embodiment of the laminated glass interlayer, all adhesive strengths to a PET film measured at an initial stage, after 500 hours, and after 1000 hours using the following method are 15 N/15 mm or more,

(Method)
glass having a thickness of 3.9 mm (a non-tin surface is an adhesive surface), a sheet having a thickness of 300 µm and formed of the adhesive resin composition, and a PET film (non-corona treated) having a thickness of 100 µm are laminated in this order and are bonded at a heating temperature of 140°C and a pressure of 1 atm during heating for a heating time of 60 minutes to prepare a glass laminate, subsequently the glass laminate is left to stand in the atmosphere and is slowly cooled by natural cooling, a slit having a width of 15 mm is formed in a sheet portion of the obtained glass laminate to obtain a test piece and the test piece is provided in a tensile tester, a PET film is peeled off at a tension rate of 100 mm/min and a peel angle of 180° and an average stress is obtained as an initial stage adhesive strength (N/15 mm) , and the glass laminate is stored under conditions of 85°C and a relative humidity of 90% to obtain an adhesive strength of the glass laminate after the storage for 500 hours and an adhesive strength of the glass laminate after the storage for 1000 hours, respectively.

According to an embodiment of the laminated glass interlayer, an adhesive strength to a PET film measured after the storage of 1000 hours using the following method is 50 N/15 mm or more,

(Method)
glass having a thickness of 3.9 mm (a non-tin surface is an adhesive surface), a sheet having a thickness of 300 µm and formed of the adhesive resin composition, and a PET film (non-corona treated) having a thickness of 100 µm are laminated in this order and are bonded at a heating temperature of 140°C and a pressure of 1 atm during heating for a heating time of 60 minutes to prepare a glass laminate, subsequently the glass laminate is left to stand in the atmosphere and is slowly cooled by natural cooling, subsequently the glass laminate is stored under conditions of 85°C and a relative humidity of 90% for 1000 hours, a slit having a width of 15 mm is formed in a sheet portion of the obtained glass laminate to obtain a test piece and the test piece is provided in a tensile tester, and a PET film is peeled off at a tension rate of 100 mm/min and a peel angle of 180° and an average stress is obtained as an adhesive strength (N/15 mm) to the PET film after the storage for 1000 hours.

According to an embodiment of the laminated glass interlayer,
the ionomer resin layer and the adhesive resin layer are adjacent to each other, and
the polyester resin layer is adjacent to a surface of the adhesive resin layer opposite to a surface adjacent to the ionomer resin layer.

The laminated glass according to the invention includes:
the laminated glass interlayer according to the invention; and
a transparent plate-like member that is provided on both surfaces of the laminated glass interlayer.

According to an embodiment the laminated glass includes at least one configuration where the transparent plate-like member and the ionomer resin layer are adjacent to each other.

The solar cell encapsulant according to the invention includes, in the following order:
an ionomer resin layer that includes an ionomer (C) of an ethylene-unsaturated carboxylic acid-based copolymer;
an adhesive resin layer that includes an adhesive resin composition; and
a polyester resin layer that includes a polyester resin (D), the adhesive resin composition comprising:
   an ethylene-unsaturated ester copolymer (A); and
   an epoxy group-containing ethylene-based copolymer (B) (other than the ethylene-unsaturated ester copolymer (A)),
   wherein a content of a constituent unit derived from an unsaturated ester in the ethylene-unsaturated ester copolymer (A) is more than 20 mass% with respect to all constituent units forming the ethylene-unsaturated ester copolymer (A), and
   an absolute value of a difference (X₁ - X₂) between a content (X₁) of a constituent unit derived from ethylene with respect to all the constituent units forming the ethylene-unsaturated ester copolymer (A) and a content (X₂) of a constituent unit derived from ethylene with respect to all constituent units forming the epoxy group-containing ethylene-based copolymer (B) is 10 mass% or less.

The solar cell module according to the invention comprises:
a solar cell element; and
an encapsulating resin layer that is formed of the solar cell encapsulant according to the invention to encapsulate the solar cell element.

### ADVANTAGEOUS EFFECTS OF INVENTION

According to the present invention, it is possible to provide a laminated glass interlayer having improved transparency, adhesiveness to a polyester resin layer, and adhesiveness to glass, a laminated glass, a solar cell encapsulant, and a solar cell module.

### DESCRIPTION OF EMBODIMENTS

Hereinafter, the present invention will be described based on embodiments. In the present specification, "A to B" indicating a numerical range represents "A or more and B or less" unless otherwise specified. In addition, "(meth) acrylic acid" represents "at least one selected from the group consisting of acrylic acid and methacrylic acid", and "(meth)acrylate" means "at least one selected from the group consisting of acrylate and methacrylate".

### 1. Adhesive Resin Composition

An adhesive resin composition according to the present disclosure includes: an ethylene-unsaturated ester copolymer (A) (hereinafter, also referred to as "copolymer (A)"); and an epoxy group-containing ethylene-based copolymer (B) (hereinafter, also referred to as "copolymer (B)"), in which a content of a constituent unit derived from an unsaturated ester in the ethylene-unsaturated ester copolymer (A) is more than 20 mass% with respect to all constituent units forming the ethylene-unsaturated ester copolymer (A), and an absolute value of a difference (X₁ - X₂) (hereinafter, also referred to as "ethylene content difference") between a content (X₁) of a constituent unit derived from ethylene with respect to all the constituent units forming the ethylene-unsaturated ester copolymer (A) and a content (X₂) of a constituent unit derived from ethylene with respect to all constituent units forming the epoxy group-containing ethylene-based copolymer (B) is 10 mass% or less. Note that the ethylene-unsaturated ester copolymer (A) is excluded from the epoxy group-containing ethylene-based copolymer (B).

In the adhesive resin composition according to the present disclosure, transparency and adhesiveness to a polyester resin layer can be improved. In addition, with the adhesive resin composition according to the present disclosure, a laminated glass interlayer having improved transparency, adhesiveness to a polyester resin layer, and adhesiveness to glass, laminated glass, a solar cell encapsulant, and a solar cell module can be realized.

The reason why this effect can be obtained is presumed as follows.

First, it is considered that adhesiveness to a polyester resin layer can be improved by using the ethylene-unsaturated ester copolymer (A) and the epoxy group-containing ethylene-based copolymer (B) in combination. It is considered that the crystallinity of the ethylene-unsaturated ester copolymer (A) is lowered by setting the content of the constituent unit derived from the unsaturated ester in the ethylene-unsaturated ester copolymer (A) to be the above-described lower limit value or more, the compatibility between the ethylene-unsaturated ester copolymer (A) and the epoxy group-containing ethylene-based copolymer (B) is improved by setting the ethylene content difference to be the above-described upper limit value or less, and the transparency can be improved by setting a difference in refractive index between the respective copolymers to be low.

In the adhesive resin composition according to the present disclosure, the ethylene content difference is 10 mass% or less but, from the viewpoint of further improving transparency and adhesiveness to a polyester resin layer, is preferably 8 mass% or less, more preferably 6 mass% or less, still more preferably 4 mass% or less, and still more preferably 3 mass% or less, and is preferably 0 mass% or more.

When a total content of the ethylene-unsaturated ester copolymer (A) and the epoxy group-containing ethylene-based copolymer (B) in the adhesive resin composition according to the present disclosure is represented by 100 mass%, the content of the ethylene-unsaturated ester copolymer (A) is preferably 40 mass% or more, more preferably 45 mass% or more, and still more preferably 50 mass% or more from the viewpoint of further improving transparency, adhesiveness to a polyester resin layer, and workability, and is preferably 99 mass% or less, more preferably 97 mass% or less, and still more preferably 95 mass% or less from the viewpoint of further improving transparency, adhesiveness to a polyester resin layer, and workability.

When a total content of the adhesive resin composition is represented by 100 mass%, a total content of the ethylene-unsaturated ester copolymer (A) and the epoxy group-containing ethylene-based copolymer (B) in the adhesive resin composition according to the present disclosure is preferably 70 mass% or more, more preferably 80 mass% or more, still more preferably 90 mass% or more, and still more preferably 95 mass% or more, and is preferably 100 mass% or less from the viewpoint of further improving transparency and adhesiveness to a polyester resin layer.

Hereinafter, each of the components forming the adhesive resin composition according to the present disclosure will be described.

### <Ethylene-Unsaturated Ester Copolymer (A)>

The ethylene-unsaturated ester copolymer (A) is a polymer obtained by copolymerizing ethylene and at least one unsaturated ester. Examples of the ethylene-unsaturated ester copolymer (A) include a copolymer including ethylene and an unsaturated ester.

In addition, it is preferable that the ethylene-unsaturated ester copolymer (A) includes at least one polymer selected from the group consisting of an ethylene-vinyl ester copolymer and an ethylene-unsaturated carboxylic acid ester copolymer.

Further, the ethylene-unsaturated ester copolymer (A) may include a polymerizable monomer other than ethylene and the unsaturated ester, and examples thereof include an olefin such as propylene, butene, or hexene.

As the ethylene-vinyl ester copolymer, for example, at least one kind selected from the group consisting of an ethylene-vinyl acetate copolymer, an ethylene-vinyl propionate copolymer, an ethylene-vinyl butyrate copolymer, and an ethylene-vinyl stearate copolymer can be used.

The ethylene-unsaturated carboxylic acid ester copolymer is a polymer obtained by copolymerizing ethylene and at least one unsaturated carboxylic acid ester.

Specific examples of the ethylene-unsaturated carboxylic acid ester copolymer include a copolymer including ethylene and an unsaturated carboxylic acid alkyl ester.

As the unsaturated carboxylic acid in the unsaturated carboxylic acid ester, for example, at least one kind selected from the group consisting of acrylic acid, methacrylic acid, 2-ethylacrylic acid, crotonic acid, maleic acid, fumaric acid, itaconic acid, maleic anhydride, fumaric anhydride, itaconic anhydride, monomethyl maleate, monoethyl maleate, and the like can be used.

Among these, from the viewpoint of improving productivity and hygiene of the ethylene-unsaturated ester copolymer (A), it is preferable that the unsaturated carboxylic acid includes at least one kind selected from the group consisting of acrylic acid and methacrylic acid.

Examples of the alkyl moiety in the unsaturated carboxylic acid alkyl ester include an alkyl moiety having 1 or more and 12 or less carbon atoms, more specifically, an alkyl group such as methyl, ethyl, n-propyl, isopropyl, n-butyl, isobutyl, secondary butyl, 2-ethylhexyl, or isooctyl. In the present embodiment, the number of carbon atoms in the alkyl moiety of the alkyl ester is preferably 1 or more and 8 or less, and more preferably 1 or more and 4 or less.

It is preferable that the unsaturated carboxylic acid ester includes at least one kind selected from the group consisting of (meth)acrylic acid esters such as methyl (meth)acrylate, ethyl (meth)acrylate, isopropyl (meth) acrylate, n-propyl (meth)acrylate, isobutyl (meth)acrylate, n-butyl (meth)acrylate, isooctyl (meth) acrylate, and 2-ethylhexyl (meth)acrylate. These unsaturated carboxylic acid esters may be used alone or in combination of two or more kinds thereof. Among these, it is more preferable that the unsaturated carboxylic acid ester includes at least one kind selected from the group consisting of methyl (meth)acrylate, ethyl (meth)acrylate, isopropyl (meth) acrylate, n-propyl (meth)acrylate, isobutyl (meth)acrylate, and n-butyl (meth)acrylate.

In the present embodiment, it is preferable that the ethylene-unsaturated carboxylic acid ester copolymer is an ethylene- (meth) acrylic acid ester copolymer. Among them, a copolymer consisting of one kind of compound is preferable as the (meth) acrylic acid ester. Examples of the copolymer include at least one kind selected from the group consisting of an ethylene-methyl (meth)acrylate copolymer, an ethylene-ethyl (meth)acrylate copolymer, an ethylene-isopropyl (meth)acrylate copolymer, an ethylene-n-propyl (meth)acrylate copolymer, an ethylene-isobutyl (meth)acrylate copolymer, an ethylene-n-butyl (meth)acrylate copolymer, an ethylene-isooctyl (meth)acrylate copolymer, and an ethylene-2-ethylhexyl (meth)acrylate copolymer.

It is preferable that the ethylene-unsaturated ester copolymer (A) includes at least one kind selected from the group consisting of an ethylene-vinyl acetate copolymer, ethylene-methyl (meth) acrylate copolymer, ethylene-ethyl (meth)acrylate copolymer, ethylene-isopropyl (meth)acrylate copolymer, an ethylene-n-propyl (meth)acrylate copolymer, ethylene-isobutyl (meth)acrylate copolymer, and ethylene-n-butyl (meth) acrylate copolymer, it is more preferable that the ethylene-unsaturated ester copolymer (A) includes an ethylene-vinyl acetate copolymer, and it is still more preferable that the ethylene-unsaturated ester copolymer (A) is an ethylene-vinyl acetate copolymer.

In the present embodiment, the ethylene-unsaturated ester copolymer (A) may be used alone or in combination of two or more kinds thereof.

A melt flow rate (MFR) of the ethylene-unsaturated ester copolymer (A) measured according to JIS K 7210:1999 under conditions of 190°C and a load of 2160 g is preferably 1 g/10 minutes or more, more preferably 10 g/10 minutes or more, still more preferably 11 g/10 minutes or more, still more preferably 12 g/10 minutes or more, and still more preferably 13 g/10 minutes or more from the viewpoint of further improving transparency and adhesiveness to a polyester resin layer, and is preferably 100 g/10 minutes or less, more preferably 50 g/10 minutes or less, still more preferably 30 g/10 minutes or less, still more preferably 20 g/10 minutes or less, still more preferably 18 g/10 minutes or less, and still more preferably 15 g/10 minutes or less from the viewpoint of further improving heat resistance, mechanical strength, transparency, and the like of the obtained laminated glass interlayer or solar cell encapsulant.

The MFR of the ethylene-unsaturated ester copolymer (A) may be adjusted by blending a plurality of ethylene-unsaturated ester copolymers (A) having different MFRs. Here, when the plurality of ethylene-unsaturated ester copolymers (A) having different MFRs are blended, the MFR of the blended product is regarded as the MFR of the ethylene-unsaturated ester copolymer (A).

The content of the constituent unit derived from ethylene in the ethylene-unsaturated ester copolymer (A) with respect to all the constituent units forming the ethylene-unsaturated ester copolymer (A) is preferably 50 mass% or more, more preferably 55 mass% or more, still more preferably 60 mass% or more, and still more preferably 65 mass% or more from the viewpoint of further improving heat resistance, mechanical strength, water resistance, workability, productivity, and the like, and is preferably 80 mass% or less, more preferably 76 mass% or less, still more preferably 73 mass% or less, still more preferably 70 mass% or less, and still more preferably 68 mass% or less from the viewpoint of further improving transparency, flexibility, and adhesiveness to a polyester resin layer.

The content of the constituent unit derived from the unsaturated ester in the ethylene-unsaturated ester copolymer (A) is more than 20 mass% with respect to all constituent units forming the ethylene-unsaturated ester copolymer (A) ; however, is preferably 24 mass% or more, more preferably 27 mass% or more, still more preferably 30 mass% or more, and still more preferably 32 mass% or more from the viewpoint of further improving transparency, flexibility, and adhesiveness to a polyester resin layer, and is preferably 50 mass% or less, more preferably 45 mass% or less, still more preferably 40 mass% or less, and still more preferably 35 mass% or less from the viewpoint of further improving heat resistance, mechanical strength, water resistance, workability, productivity, and the like.

When the unsaturated ester is vinyl acetate, the content of the constituent unit derived from the unsaturated ester can be measured, for example, according to JIS K 7192:1999. In addition, when the unsaturated ester is an unsaturated carboxylic acid ester, the content of the constituent unit derived from the unsaturated ester is measured from, for example, an infrared absorption spectrum (IR) attributed to the unsaturated carboxylic acid ester. For example, when the unsaturated carboxylic acid ester is ethyl acrylate (EA), the content of the constituent unit derived from the unsaturated ester is obtained from an absorbance at 860 cm⁻¹ attributed to ethyl acrylate (EA). Note that a calibration curve is obtained from a correlation between an EA concentration obtained from a nuclear magnetic resonance spectrum (NMR) and the absorbance at 860 cm⁻¹ of IR.

A method of manufacturing the ethylene-unsaturated ester copolymer (A) is not particularly limited, and the ethylene-unsaturated ester copolymer (A) may be manufactured using a well-known method. For example, the ethylene-unsaturated ester copolymer (A) can be obtained by performing radical copolymerization of various polymerization components at a high temperature and a high pressure. A commercially available product may be used as the ethylene-unsaturated ester copolymer (A).

From the viewpoint of further improving adhesiveness, it is preferable that at least a part of the ethylene-unsaturated ester copolymer (A) is modified with a silane coupling agent.

Here, it is preferable that the silane coupling agent in the ethylene-unsaturated ester copolymer (A) includes at least one kind selected from the group consisting of a silane coupling agent having a polymerizable group, a silane coupling agent having an amino group, and a silane coupling agent having an epoxy group.

From the viewpoint of further improving adhesiveness, the content of the silane coupling agent with respect to 100 parts by mass of the ethylene-unsaturated ester copolymer (A) is preferably 0.02 parts by mass or more, more preferably 0.1 parts by mass or more, and still more preferably 0.5 parts by mass or more, and is preferably 5 parts by mass or less, more preferably 4 parts by mass or less, and still more preferably 3 parts by mass or less.

Here, the modification of the silane coupling agent to the ethylene-unsaturated ester copolymer (A) can be performed using, for example, the same method as for modification of the silane coupling agent to the epoxy group-containing ethylene-based copolymer (B) described below.

In addition, the modification of the silane coupling agent to the ethylene-unsaturated ester copolymer (A) and the modification of the silane coupling agent to the epoxy group-containing ethylene-based copolymer (B) may be performed at the same time.

When the modification of the silane coupling agent to the ethylene-unsaturated ester copolymer (A) and the modification of the silane coupling agent to the epoxy group-containing ethylene-based copolymer (B) are performed at the same time, the content of a polymerization initiator used for the modification with respect to 100 parts by mass of the total content of the ethylene-unsaturated ester copolymer (A) and the epoxy group-containing ethylene-based copolymer (B) is preferably 0.05 parts by mass or more, more preferably 0.1 parts by mass or more, still more preferably 0.2 parts by mass or more, and is preferably 5 parts by mass or less, more preferably 3 parts by mass or less, still more preferably 1.5 parts by mass or less, still more preferably 1 part by mass or less, and still more preferably 0.3 parts by mass or less.

From the viewpoint of further improving adhesiveness, the content of the silane coupling agent with respect to 100 parts by mass of the total content of the ethylene-unsaturated ester copolymer (A) and the epoxy group-containing ethylene-based copolymer (B) is preferably 0.02 parts by mass or more, more preferably 0.1 parts by mass or more, and still more preferably 0.5 parts by mass or more, and is preferably 5 parts by mass or less, more preferably 4 parts by mass or less, still more preferably 3 parts by mass or less, and still more preferably 1.5 parts by mass or less.

### <Epoxy Group-Containing Ethylene-Based Copolymer (B)>

Examples of the epoxy group-containing ethylene-based copolymer (B) include a glycidyl group-containing ethylene-based copolymer.

From the viewpoint of further improving transparency and the adhesiveness to a polyester resin layer, as the glycidyl group-containing ethylene-based copolymer, at least one kind selected from the group consisting of an ethylene-glycidyl (meth)acrylate copolymer, an ethylene-glycidyl (meth)acrylate-vinyl acetate copolymer, and an ethylene-glycidyl (meth)acrylate- (meth)acrylic acid ester copolymer is preferable, an ethylene-glycidyl (meth)acrylate- (meth)acrylic acid ester copolymer is more preferable, an ethylene-glycidyl (meth)acrylate-methyl (meth)acrylate copolymer is still more preferable, and an ethylene-glycidyl methacrylate-methyl acrylate copolymer is still more preferable.

The epoxy group-containing ethylene-based copolymer (B) can be obtained by copolymerizing a monomer having a polymerizable group and an epoxy group, such as glycidyl (meth)acrylate, glycidyl vinyl ether, 1,2-epoxy-4-vinylcyclohexane, or 3,4-epoxycyclohexylmethyl methacrylate, with ethylene. In addition, an epoxy group may be introduced into an ethylene-based copolymer by graft polymerization of a monomer having an epoxy group.

The content of the constituent unit derived from the monomer having an epoxy group in the epoxy group-containing ethylene-based copolymer (B) with respect to all the constituent units forming the epoxy group-containing ethylene-based copolymer (B) is preferably 0.5 mass% or more, more preferably 1 mass% or more, still more preferably 2 mass% or more, and still more preferably 3 mass% or more from the viewpoint of further improving adhesiveness, transparency, and flexibility, and is preferably 30 mass% or less, more preferably 20 mass% or less, still more preferably 10 mass% or less, still more preferably 8 mass% or less, and still more preferably 6 mass% or less from the viewpoint of further improving workability.

"Glycidyl (meth) acrylate" represents at least one kind selected from the group consisting of glycidyl methacrylate and glycidyl acrylate.

The "ethylene-based copolymer" in the epoxy group-containing ethylene-based copolymer (B) represents that the constituent unit derived from ethylene is the main component. Furthermore, the "main component" described herein represents that the content of the "constituent unit derived from ethylene" is the highest among all the constituent units. For example, in the case of a copolymer consisting of constituent units derived from ethylene, glycidyl (meth)acrylate, and vinyl acetate, respectively, this represents that the ratio of the constituent unit derived from ethylene is more than that of the constituent unit derived from glycidyl (meth)acrylate or the constituent unit derived from vinyl acetate.

The content of the constituent unit derived from ethylene in the epoxy group-containing ethylene-based copolymer (B) with respect to all the constituent units forming the epoxy group-containing ethylene-based copolymer (B) is preferably 50 mass% or more, more preferably 55 mass% or more, still more preferably 60 mass% or more, still more preferably 65 mass% or more, and still more preferably 67 mass% or more from the viewpoint of further improving productivity, and is preferably 82 mass% or less, more preferably 80 mass% or less, still more preferably 78 mass% or less, still more preferably 75 mass% or less, still more preferably 72 mass% or less, and still more preferably 70 mass% or less from the viewpoint of further improving transparency and adhesiveness to a polyester resin layer.

The epoxy group-containing ethylene-based copolymer (B) may further include monomer units other than ethylene and the monomer having an epoxy group.

Examples of the other monomers include vinyl esters such as vinyl acetate and vinyl propionate; and unsaturated carboxylic acid esters such as acrylic acid ester, methacrylic acid ester, ethacrylic acid ester, crotonic acid ester, fumaric acid ester, maleic acid ester, maleic anhydride ester, itaconic acid ester, and itaconic anhydride ester. Examples of the ester group include an alkyl ester group having 1 or more and 12 or less carbon atoms, more specifically, an alkyl ester group such as methyl ester, ethyl ester, n-propyl ester, isopropyl ester, n-butyl ester, isobutyl ester, secondary butyl ester, 2-ethylhexyl ester, or isooctyl ester.

Among these, at least one kind selected from the group consisting of vinyl acetate and (meth)acrylic acid ester is preferable.

Specifically, in addition to the copolymer including the constituent unit derived from ethylene and the constituent unit derived from glycidyl (meth)acrylate, for example, a copolymer including not only the two constituent units but also at least one constituent unit selected from the group consisting of a constituent unit derived from vinyl acetate and a constituent unit derived from (meth)acrylic acid ester can be used.

From the viewpoint of further improving transparency and adhesiveness to glass or a polyester resin layer, the content of constituent units derived from the monomer units other than ethylene and the monomer having an epoxy group in the epoxy group-containing ethylene-based copolymer (B) with respect to all the constituent units forming the epoxy group-containing ethylene-based copolymer (B) is preferably 1 mass% or more, more preferably 5 mass% or more, still more preferably 10 mass% or more, still more preferably 15 mass% or more, still more preferably 20 mass% or more, still more preferably 25 mass% or more, and still more preferably 26 mass% or more, and is preferably 40 mass% or less, more preferably 35 mass% or less, still more preferably 30 mass% or less, still more preferably 29 mass% or less, and still more preferably 28 mass% or less.

The epoxy group-containing ethylene-based copolymer (B) may be used alone or in combination of two or more kinds thereof.

From the viewpoint of further improving adhesiveness to glass or a polyester resin layer, it is preferable that at least a part of the epoxy group-containing ethylene-based copolymer (B) is modified with a silane coupling agent.

Here, in the adhesive resin composition according to the present disclosure, it is preferable that the silane coupling agent in the epoxy group-containing ethylene-based copolymer (B) includes at least one kind selected from the group consisting of a silane coupling agent having a polymerizable group, a silane coupling agent having an amino group, and a silane coupling agent having an epoxy group.

Here, the modification of the silane coupling agent to the epoxy group-containing ethylene-based copolymer (B) is performed using, for example, a method of causing the epoxy group-containing ethylene-based copolymer (B) and the silane coupling agent having an amino group or an epoxy group to react with each other under heating (at, for example, 100°C or higher and 200°C or lower) (modification method 1), a method of performing graft polymerization of the epoxy group-containing ethylene-based copolymer (B) with the silane coupling agent having a polymerizable group using a polymerization initiator (modification method 2), or the like.

In the modification method 1, by causing the amino group or the epoxy group in the silane coupling agent and the glycidyl group in the epoxy group-containing ethylene-based copolymer (B) to react with each other, the silane coupling agent is introduced into a side chain of the epoxy group-containing ethylene-based copolymer (B).

In the modification method 2, for example, the epoxy group-containing ethylene-based copolymer (B), the silane coupling agent having a polymerizable group, and a radical polymerization initiator can be melt-kneaded for manufacturing using an extruder, a kneader, a Banbury mixer, or the like at a temperature equal to or higher than a melting point of the epoxy group-containing ethylene-based copolymer (B) and equal to or higher than a decomposition temperature of the radical polymerization initiator. These reactions can also be performed in solutions.

As the polymerization initiator, a polymerization initiator that is typically used can be used, but an organic peroxide is preferable.

As the organic peroxide, a well-known organic peroxide that can be used as a polymerization initiator can be used, and specific examples thereof include a diacyl peroxide compound, an alkyl peroxy ester compound, a peroxydicarbonate compound, a peroxycarbonate compound, a peroxyketal compound, a dialkyl peroxide compound, a hydroperoxide compound, and a ketone peroxide compound.

Among these, a dialkyl peroxide compound is preferable, and 2,5-dimethyl-2,5-di(t-butylperoxy)hexane, 1,3-di(2-t-butylperoxyisopropyl)benzene, di-t-butyl peroxide, or 2,5-dimethyl-2,5-di(t-butylperoxy)hexyne-3 is more preferable.

Examples of the silane coupling agent having a polymerizable group include vinyltrimethoxysilane, vinyltriethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropylmethyldimethoxysilane, 3-acryloxypropyltrimethoxysilane, 3-acryloxypropylmethyldiethoxysilane, and 3-acryloxypropyltriethoxysilane.

Examples of the silane coupling agent having an amino group include hydrochlorides of N-(2-aminoethyl)-3-aminopropyltrimethoxysilane, N-(2-aminoethyl)-3-aminopropylmethyldimethoxysilane, N-2-(aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane, and N-(vinylbenzyl)-2-aminoethyl-3-aminopropyltrimethoxysilane.

Examples of the silane coupling agent having an epoxy group include 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, and 3-glycidoxypropyltriethoxysilane.

From the viewpoint of further improving adhesiveness to glass or a polyester resin layer, the content of the polymerization initiator used for modification with respect to 100 parts by mass of the epoxy group-containing ethylene-based copolymer (B) is preferably 0.1 parts by mass or more and more preferably 0.3 parts by mass or more, and is preferably 5 parts by mass or less, more preferably 3 parts by mass or less, still more preferably 1.0 part by mass or less, and still more preferably 0.6 parts by mass or less.

From the viewpoint of further improving adhesiveness to glass or a polyester resin layer, the content of the silane coupling agent with respect to 100 parts by mass of the epoxy group-containing ethylene-based copolymer (B) is preferably 0.02 parts by mass or more, and is preferably 5 parts by mass or less, more preferably 4 parts by mass or less, and still more preferably 3 parts by mass or less.

A Vicat softening point of the epoxy group-containing ethylene-based copolymer (B) defined according to JIS K 7206:1999 is preferably 65°C or lower, more preferably 50°C or lower, still more preferably 40°C or lower, still more preferably 30°C or lower, and still more preferably 25°C or lower from the viewpoint of further improving adhesiveness to glass or a polyester resin layer, and is preferably 20°C or higher from the viewpoint of heat resistance or workability.

From the viewpoint of further improving adhesiveness to glass or a polyester resin layer, a melting point of the epoxy group-containing ethylene-based copolymer (B), which is measured according to JIS K 7121 :1987 is preferably 90°C or lower, more preferably 80°C or lower, still more preferably 70°C or lower, still more preferably 65°C or lower, and still more preferably 60°C or lower from the viewpoint of further improving adhesiveness to glass or a polyester resin layer, and is preferably 30°C or higher, more preferably 40°C or higher, still more preferably 45°C or higher, and still more preferably 52°C or higher from the viewpoint of heat resistance or workability.

From the viewpoint of further improving processing stability, the melt flow rate (MFR) of the epoxy group-containing ethylene-based copolymer (B) measured according to JIS K 7210:1999 under conditions of 190°C and a load of 2160 g is preferably 0.1 g/10 min or more, more preferably 1 g/10 min or more, still more preferably 2 g/10 min or more, still more preferably 3 g/10 min or more, and still more preferably 4 g/10 min or more, and is preferably 100 g/10 min or less, more preferably 50 g/10 min or less, still more preferably 20 g/10 min or less, and still more preferably 10 g/10 min or less.

### <Other Components>

The adhesive resin composition according to the present disclosure can include components other than the ethylene-unsaturated ester copolymer (A) and the epoxy group-containing ethylene-based copolymer (B) within a range where the object of the present invention does not deteriorate. The other components are not particularly limited, and examples thereof include a plasticizer, an antioxidant, an ultraviolet absorber, a wavelength conversion agent, an antistatic agent, a surfactant, a colorant, a lightfastness stabilizer, a foaming agent, a lubricating agent, a crystal nucleating agent, a crystallization accelerator, a crystallization retardant, a catalyst deactivator, a heat ray absorber, a heat ray reflecting agent, a heat dissipating agent, a thermoplastic resin, a thermosetting resin, an inorganic filler, an organic filler, an impact resistance improving agent, a slip agent, a cross-linking agent, a cross-linking aid, a silane coupling agent, a tackifier, a processing aid, a mold release agent, a hydrolysis inhibitor, a heat-resistant stabilizer, an antiblocking agent, an antifogging agent, a flame retardant, a flame retardant aid, a light diffusing agent, an antibacterial agent, an antifungal agent, a dispersant, and other resins. The other components may be used alone or in combination of two or more kinds thereof.

From the viewpoint of further improving transparency, in the adhesive resin composition according to the present disclosure, a haze measured using the following method is preferably 10% or less, more preferably 9% or less, and still more preferably 8.4% or less.

### (Method)

The adhesive resin composition is pressed under conditions of 140°C and 9.8 MPa and is subsequently cooled under conditions of 20°C and 14.7 MPa to prepare a press sheet having a thickness of 3 mm. Subsequently a haze of the obtained press sheet is measured by a haze meter according to JIS K 7136:2000.

In the adhesive resin composition according to the present disclosure, from the viewpoint of further improving the transparency of the obtained laminated glass or the solar cell module, the haze measured by the following method, is preferably 5% or less, more preferably 4% or less, and still more preferably 3.0% or less.

### (Method)

Glass having a thickness of 3.2 mm, an ionomer resin layer having a thickness of 1500 µm, a sheet having a thickness of 100 µm and formed of the adhesive resin composition, and glass having a thickness of 3.2 mm are laminated in this order and are bonded at a heating temperature of 140°C and a pressure of 1 atm during heating for a heating time of 20 minutes. The obtained laminate is slowly cooled by natural cooling to prepare a glass laminate for optical characteristics evaluation. Subsequently a haze of the obtained glass laminate is measured by a haze meter according to JIS K 7136:2000.

In the adhesive resin composition according to the present disclosure, from the viewpoint of further improving adhesiveness to a polyester resin layer, all adhesive strengths to a PET film measured at an initial stage, after 500 hours, and after 1000 hours using the following method are preferably 15 N/15 mm or more, more preferably 18 N/15 mm or more, and still more preferably 20 N/15 mm or more.

### (Method)

Glass having a thickness of 3.9 mm (a non-tin surface is an adhesive surface), a sheet having a thickness of 300 µm and formed of the adhesive resin composition, and a PET film (non-corona treated) having a thickness of 100 µm are laminated in this order and are bonded at a heating temperature of 140°C and a pressure of 1 atm during heating for a heating time of 60 minutes to prepare a glass laminate. Subsequently the glass laminate is left to stand in the atmosphere and is slowly cooled by natural cooling. A slit having a width of 15 mm is formed in a sheet portion of the obtained glass laminate to obtain a test piece and the test piece is provided in a tensile tester. A PET film is peeled off at a tension rate of 100 mm/min and a peel angle of 180° and an average stress is obtained as an initial stage adhesive strength (N/15 mm). Here, the average stress represents an average value of the stress measured during the peeling of the PET film. The glass laminate is stored under conditions of 85°C and a relative humidity of 90% to obtain an adhesive strength of the glass laminate after the storage for 500 hours and an adhesive strength of the glass laminate after the storage for 1000 hours, respectively.

In the adhesive resin composition according to the present disclosure, from the viewpoint of further improving adhesiveness to a polyester resin layer, an adhesive strength to a PET film measured after the storage of 1000 hours using the following method is preferably 50 N/15 mm or more, more preferably 70 N/15 mm or more, still more preferably 85 N/15 mm or more, and still more preferably 89.6 N/15 mm or more.

### (Method)

Glass having a thickness of 3.9 mm (a non-tin surface is an adhesive surface), a sheet having a thickness of 300 µm and formed of the adhesive resin composition, and a PET film (non-corona treated) having a thickness of 100 µm are laminated in this order and are bonded at a heating temperature of 140°C and a pressure of 1 atm during heating for a heating time of 60 minutes to prepare a glass laminate. Subsequently the glass laminate is left to stand in the atmosphere and is slowly cooled by natural cooling. Subsequently the glass laminate is stored under conditions of 85°C and a relative humidity of 90% for 1000 hours. A slit having a width of 15 mm is formed in a sheet portion of the obtained glass laminate to obtain a test piece and the test piece is provided in a tensile tester. A PET film is peeled off at a tension rate of 100 mm/min and a peel angle of 180° and an average stress is obtained as an adhesive strength (N/15 mm) to the PET film after the storage for 1000 hours.

### 2. Laminated Glass Interlayer

The laminated glass interlayer according to the present invention includes an adhesive resin layer including the adhesive resin composition according to the present disclosure.

The laminated glass interlayer according to the present invention may have a single-layer configuration or a multilayer configuration of two or more layers.

More specifically, the laminated glass interlayer according to the present invention may be a film having a single-layer configuration consisting of one adhesive resin layer, may be a film having a multilayer configuration consisting of two or more adhesive resin layers, or may be a film having a multilayer configuration including at least one adhesive resin layer and at least one layer other than the adhesive resin layer.

The thickness of the adhesive resin layer is preferably 5 µm or more, more preferably 10 µm or more, still more preferably 20 µm or more, still more preferably 30 µm or more, still more preferably 50 µm or more, and still more preferably 75 µm or more from the viewpoint of further improving adhesive strength and design properties, and is preferably 2000 µm or less, more preferably 1500 µm or less, still more preferably 1000 µm or less, still more preferably 500 µm or less, and still more preferably 400 µm or less from the viewpoint of further improving the transparency or the heat resistance of the obtained laminated glass or solar cell module.

From the viewpoint of further improving the transparency and the adhesiveness to glass, it is preferable that the laminated glass interlayer according to the present invention has a multilayer configuration including: an ionomer resin layer that includes the ionomer (C) of the ethylene-unsaturated carboxylic acid-based copolymer; and an adhesive resin layer that includes the adhesive resin composition according to the present disclosure.

When the laminated glass interlayer according to the present invention has the multilayer configuration including the ionomer resin layer and the adhesive resin layer, the laminated glass interlayer may have a two-layer configuration including the ionomer resin layer and the adhesive resin layer, or may have a three-layer configuration including the ionomer resin layer and two adhesive resin layers formed on both surfaces of the ionomer resin layer such that the ionomer resin layer is interposed between the two adhesive resin layers.

When the laminated glass interlayer according to the present invention has the multilayer configuration including the ionomer resin layer and the adhesive resin layer, a ratio (a/b) of a thickness of the ionomer resin layer (thickness a) and a thickness of the adhesive resin layer (thickness b) is preferably 3/1 or more and 80/1 or less and more preferably 7/1 or more and 30/1 or less from the viewpoint of further improving adhesiveness to glass and transparency.

From the viewpoint of further improving adhesiveness to glass, transparency, interlayer adhesiveness, and design properties, it is more preferable that the laminated glass interlayer according to the present invention has a multilayer configuration including, in the following order: an ionomer resin layer that includes the ionomer (C) of the ethylene-unsaturated carboxylic acid-based copolymer; an adhesive resin layer that includes the adhesive resin composition according to the present disclosure; and a polyester resin layer that includes a polyester resin (D).

When the laminated glass interlayer according to the present invention has the multilayer configuration including the ionomer resin layer, the adhesive resin layer according to the present disclosure, and the polyester resin layer in this order, from the viewpoint of further improving the interlayer adhesiveness of the laminated glass interlayer according to the present invention, it is preferable that, in the multilayer configuration, the ionomer resin layer and the adhesive resin layer according to the present disclosure are adjacent to each other, and the polyester resin layer is adjacent to a surface of the adhesive resin layer according to the present disclosure opposite to a surface adjacent to the ionomer resin layer.

When the laminated glass interlayer according to the present invention has the multilayer configuration including the ionomer resin layer, the adhesive resin layer, and the polyester resin layer, a ratio (a/b) of a thickness of the ionomer resin layer (thickness a) and a thickness of the adhesive resin layer (thickness b) is preferably 3/1 or more and 80/1 or less and more preferably 7/1 or more and 30/1 or less from the viewpoint of further improving adhesiveness and transparency.

### <Ionomer Resin Layer>

The ionomer resin layer includes an ionomer (C) of an ethylene-unsaturated carboxylic acid-based copolymer (hereinafter, also referred to as "ionomer (C)"), and preferably includes the ionomer (C) as a main component.

Here, the "main component" represents that the content of the ionomer (C) in the ionomer resin layer is 50 mass% or more.

From the viewpoint of further improving adhesiveness to glass, when the total content of the ionomer resin layer is represented by 100 mass%, the content of the ionomer (C) in the ionomer resin layer is preferably 60 mass% or more, more preferably 70 mass% or more, still more preferably 80 mass% or more, still more preferably 90 mass% or more, and still more preferably 95 mass% or more. The upper limit of the ionomer (C) in the ionomer resin layer is not particularly limited, but is, for example, 100 mass% or less.

The thickness of the ionomer resin layer is preferably 10 µm or more, more preferably 50 µm or more, still more preferably 100 µm or more, still more preferably 250 µm or more, still more preferably 500 µm or more, still more preferably 750 µm or more, and still more preferably 1000 µm or more from the viewpoint of further improving mechanical strength, and is preferably 5000 µm or less, more preferably 3000 µm or less, and still more preferably 2000 µm or less from the viewpoint of further improving the transparency of the obtained laminated glass or solar cell module.

The ionomer (C) of the ethylene-unsaturated carboxylic acid-based copolymer is an ionomer of a polymer obtained by copolymerizing ethylene and at least one unsaturated carboxylic acid, which is a resin where at least a part of a carboxyl group is neutralized by metal ions with respect to the ethylene-unsaturated carboxylic acid-based copolymer.

The ethylene-unsaturated carboxylic acid-based copolymer that is a base resin of the ionomer (C) of the ethylene-unsaturated carboxylic acid-based copolymer is a polymer obtained by copolymerizing at least ethylene and an unsaturated carboxylic acid as copolymerization components, and a monomer other than ethylene and the unsaturated carboxylic acid may be optionally further copolymerized.

The ethylene-unsaturated carboxylic acid-based copolymer may be used alone or in combination of two or more kinds.

The morphology of the ethylene-unsaturated carboxylic acid-based copolymer may be any of a block copolymer, a random copolymer, or a graft copolymer. In consideration of productivity, a binary random copolymer, a ternary random copolymer, a graft copolymer of a binary random copolymer, or a graft copolymer of a ternary random copolymer is preferably used, and a binary random copolymer or a ternary random copolymer is more preferable.

Examples of the unsaturated carboxylic acid forming the ethylene-unsaturated carboxylic acid-based copolymer include an unsaturated carboxylic acid having 4 or more and 8 or less carbon atoms such as acrylic acid, methacrylic acid, ethacrylic acid, itaconic acid, itaconic anhydride, fumaric acid, crotonic acid, maleic acid, maleic anhydride, monoester maleate (monomethyl maleate, monoethyl maleate, and the like), and maleic anhydride monoester (maleic anhydride monomethyl, maleic anhydride monoethyl, and the like) or half esters.

Among these, it is preferable that the unsaturated carboxylic acid includes at least one kind selected from acrylic acid and methacrylic acid from the viewpoint of improving the productivity of the ethylene-unsaturated carboxylic acid-based copolymer. These unsaturated carboxylic acid may be used alone or in combination of two or more kinds thereof.

From the viewpoint of further improving heat resistance and workability, when a total content of all the constituent units of the ethylene-unsaturated carboxylic acid-based copolymer is represented by 100 mass%, the content of a constituent unit derived from ethylene is preferably 65 mass% or more, more preferably 70 mass% or more, and still more preferably 75 mass% or more, and is preferably 95 mass% or less, more preferably 90 mass% or less, and still more preferably 85 mass% or less.

From the viewpoint of further improving transparency and adhesiveness, when a total content of all the constituent units of the ethylene-unsaturated carboxylic acid-based copolymer are represented by 100 mass%, the content of a constituent unit derived from the unsaturated carboxylic acid is preferably 5 mass% or more, more preferably 10 mass% or more, still more preferably 15 mass% or more, still more preferably 18 mass% or more, and still more preferably 19 mass% or more, and is preferably 35 mass% or less, more preferably 30 mass% or less, still more preferably 25 mass% or less, still more preferably 22 mass% or less, and still more preferably 21 mass% or less.

The content of the unsaturated carboxylic acid in the ethylene-unsaturated carboxylic acid-based copolymer can be measured by, for example, Fourier transform infrared absorption spectroscopy (FT-IR) .

The ethylene-unsaturated carboxylic acid-based copolymer is a copolymer obtained by copolymerizing at least ethylene and an unsaturated carboxylic acid, and may be multi-component copolymer with three or more components obtained by further copolymerizing a third copolymerization component.

Examples of the third copolymerization component include an unsaturated carboxylic acid ester (for example, a (meth) acrylic acid alkyl ester such as methyl acrylate, ethyl acrylate, isobutyl acrylate, n-butyl acrylate, isooctyl acrylate, 2-ethylhexyl acrylate, methyl methacrylate, ethyl methacrylate, isobutyl methacrylate, n-butyl methacrylate, isooctyl methacrylate, 2-ethylhexyl methacrylate, dimethyl maleate, or diethyl maleate), a vinyl ester (for example, vinyl acetate or vinyl propionate), an unsaturated hydrocarbon (for example, propylene, butene, 1,3-butadiene, pentene, 1,3-pentadiene, or 1-hexene), an oxide such as vinyl sulfate or vinyl nitrate, a halogenated compound (for example, vinyl chloride or vinyl fluoride), a vinyl group-containing primary or secondary amine compound, carbon monoxide, and sulfur dioxide.

Among these, as the third copolymerization component, an unsaturated carboxylic acid ester is preferable, and a (meth) acrylic acid alkyl ester (the number of carbon atoms in the alkyl moiety is preferably 1 or more and 4 or less) is more preferable.

A content ratio of a constituent unit derived from the third copolymerization component in the ethylene- (meth) acrylic acid-based copolymer is preferably in a range of 25 mass% or less from the viewpoint of production and mixing.

Examples of the metal ions forming the ionomer (C) of the ethylene-unsaturated carboxylic acid-based copolymer include: alkali metal ions such as lithium ions, potassium ions, or sodium ions; and polyvalent metal ions such as calcium ions, magnesium ions, zinc ions, aluminum ions, or barium ions. The metal ions may be used alone or in combination of two or more kinds.

Among these, it is preferable to include at least one kind selected from sodium ions, zinc ions, and magnesium ions, and it is more preferable to contain magnesium ions.

A degree of neutralization of the ionomer (C) of the ethylene-unsaturated carboxylic acid-based copolymer is preferably 5 mol% or more, more preferably 10 mol% or more, still more preferably 20 mol% or more, still more preferably 30 mol% or more, and still more preferably 40 mol% or more from the viewpoint of further improving transparency, and is preferably 95 mol% or less, more preferably 90 mol% or less, still more preferably 80 mol% or less, still more preferably 70 mol% or less, still more preferably 60 mol% or less, still more preferably 50 mol% or less, still more preferably 45 mol% or less from the viewpoint of further improving adhesiveness, workability, and moldability.

The degree of neutralization of the ionomer (C) of the ethylene-unsaturated carboxylic acid-based copolymer can be measured using, for example, a burned residue analysis method.

A method of manufacturing the ionomer (C) of the ethylene-unsaturated carboxylic acid-based copolymer is not particularly limited, and a well-known method can be used for manufacturing. In addition, as the ionomer (C) of the ethylene-unsaturated carboxylic acid-based copolymer, a commercially available ionomer may be used.

From the viewpoint of further improving the interlayer adhesiveness and moldability of the laminated glass interlayer, a melt flow rate (MFR) of the ionomer (C) of the ethylene-unsaturated carboxylic acid-based copolymer measured under conditions of 190°C and a load of 2160 g according to JIS K 7210:1999 is preferably 0.1 g/10 min or more, more preferably 0.5 g/10 min or more, still more preferably 1.0 g/10 min or more, still more preferably 1.5 g/10 min or more, and still more preferably 2.0 g/10 min or more, and is preferably 30 g/10 min or less, more preferably 15 g/10 min or less, still more preferably 10 g/10 min or less, still more preferably 5 g/10 min or less, and still more preferably 3.0 g/10 min or less.

The ionomer resin layer can include components other than the ionomer (C) of the ethylene-unsaturated carboxylic acid-based copolymer within a range where the object of the present invention does not deteriorate. The other components are not particularly limited, but examples thereof include a plasticizer, an antioxidant, an ultraviolet absorber, an antistatic agent, a surfactant, a colorant, a light stabilizer, a foaming agent, a lubricating agent, a crystal nucleating agent, a crystallization accelerator, a crystallization retardant, a catalyst deactivator, a thermoplastic resin other than the ionomer (C), a thermosetting resin, an inorganic filler, an organic filler, an impact resistance improving agent, a slip agent, a cross-linking agent, a cross-linking aid, a tackifier, a silane coupling agent, a processing aid, a mold release agent, a hydrolysis inhibitor, a heat-resistant stabilizer, an antiblocking agent, an antifogging agent, a flame retardant, a flame retardant aid, a light diffusing agent, an antibacterial agent, an antifungal agent, a dispersant, and other resins. The other components may be used alone or in combination of two or more kinds thereof. Note that, it is preferable that the ionomer resin layer does not include the epoxy group-containing ethylene-based copolymer.

### <Polyester Resin Layer>

The polyester resin layer includes a polyester resin (D), and preferably includes the polyester resin (D) as a main component. Here, the "main component" represents that the content of the polyester resin (D) in the polyester resin layer is 50 mass% or more.

When the total content of the polyester resin layer is represented by 100 mass%, the content of the polyester resin (D) in the polyester resin layer is preferably 60 mass% or more, more preferably 70 mass% or more, still more preferably 80 mass% or more, still more preferably 90 mass% or more, and still more preferably 95 mass% or more. The upper limit of the polyester resin (D) in the polyester resin layer is not particularly limited, but is, for example, 100 mass% or less.

The thickness of the polyester resin layer is preferably 5 µm or more, more preferably 10 µm or more, still more preferably 20 µm or more, still more preferably 30 µm or more, still more preferably 50 µm or more, and still more preferably 75 µm or more from the viewpoint of further improving mechanical strength and design properties, and is preferably 2000 µm or less, more preferably 1000 µm or less, still more preferably 500 µm or less, still more preferably 200 µm or less, and still more preferably 150 µm or less from the viewpoint of further improving the transparency and interlayer adhesiveness of the obtained laminated glass or solar cell module.

Examples of the polyester resin (D) include polyethylene terephthalate (PET), polytrimethylene terephthalate (PTT), polybutylene terephthalate (PBT), and polyethylene naphthalate (PEN). For example, an easy adhesion treatment such as coating may be performed on a surface of the polyester resin layer. In addition, the polyester resin layer may be a film having a multilayer configuration including the plural kinds of polyester resin layers.

The polyester resin layer can be industrially manufactured as a single-layer film formed of the above-described polyester using a well-known T-die cast film method, or as a co-extruded film formed of two or more kinds of polyesters or a resin other than polyester using a co-extrusion T-die cast film method. The polyester resin layer may be a non-stretched film, but from the viewpoint of further improving the toughness, transparency, heat resistance, gas barrier properties, and the like of the film, is preferably a stretched film.

The total thickness of the laminated glass interlayer according to the present invention is preferably 0.1 mm or more, more preferably 0.2 mm or more, and still more preferably 0.3 mm or more from the viewpoint of further improving the mechanical strength, and is preferably 10 mm or less, more preferably 5 mm or less, and still more preferably 3 mm or less from the viewpoint of further improving the transparency and interlayer adhesiveness of the obtained laminated glass.

The method of manufacturing the laminated glass interlayer according to the present invention is not particularly limited, and any well-known manufacturing method can be used.

Regarding the method of manufacturing the laminated glass interlayer according to the present invention, for example, a press molding method, an extrusion molding method, a T-die molding method, an injection molding method, a compression molding method, a cast molding method, a calendar molding method, or an inflation molding method can be used.

### 3. Laminated glass

The laminated glass according to the present invention includes the laminated glass interlayer according to the present invention; and transparent plate-like members provided on both surfaces of the laminated glass interlayer. Here, in the present specification, the "transparent plate-like member" will also be referred to as "glass".

Since the laminated glass according to the present invention includes the laminated glass interlayer according to the present invention, the transparency and interlayer adhesiveness are improved.

The laminated glass interlayer may include two or more layers or may include three or more layers where a layer formed of another resin is interposed between two laminated glass interlayers.

Examples of a layer configuration of the laminated glass according to the present invention include configurations of the following Examples 1 to 3.
Example 1: transparent plate-like member/ionomer resin layer/adhesive resin layer/transparent plate-like member
Example 2: transparent plate-like member/ionomer resin layer/adhesive resin layer/polyester resin layer/adhesive resin layer/transparent plate-like member
Example 3: transparent plate-like member/ionomer resin layer/adhesive resin layer/polyester resin layer/adhesive resin layer/ionomer resin layer/transparent plate-like member

It is preferable that the layer configuration of the laminated glass according to the present invention includes at least one configuration in which the transparent plate-like member and the ionomer resin layer are adjacent to each other. By providing the ionomer resin layer between the transparent plate-like member and the adhesive resin layer, the durability of the laminated glass can be further improved.

The transparent plate-like member is not particularly limited. For example, generally used transparent plate glass can be used, and examples thereof include inorganic glass such as float plate glass, polished plate glass, figured glass, network wired plate glass, wired plate glass, colored plate glass, heat-ray absorbing plate glass, heat-ray reflective plate glass, and green glass. In addition, an organic plastic plate such as a polycarbonate plate, a poly (meth)acrylate plate, a polymethyl (meth)acrylate plate, a polystyrene plate, a cyclic polyolefin plate, a polyethylene terephthalate plate, a polyethylene naphthalate plate, or a polyethylene butyrate plate can be used. Among these, transparent plate glass is preferable, and inorganic glass is more preferable.

The transparent plate-like member may be appropriately subjected to a surface treatment such as a corona treatment, a plasma treatment, or a flame treatment.

The thickness of the transparent plate-like member is preferably 0.1 mm or more, more preferably 0.5 mm or more, and still more preferably 1 mm or more, and is preferably 20 mm or less, more preferably 10 mm or less, and still more preferably 5 mm or less. In the laminated glass according to the present invention, as the transparent plate-like members provided on both surfaces of the laminated glass interlayer, the same members may be used, or different plate-like members may be used in combination.

A method of manufacturing the laminated glass according to the present invention is not particularly limited, and for example, a well-known manufacturing method in the related art such as a nip roll method, an autoclave method, a vacuum bag method, or a vacuum laminator method can be used. These manufacturing methods may be used alone or in combination of two or more kinds thereof for manufacturing.

As the method of manufacturing the laminated glass according to the present invention, for example, a method of interposing the laminated glass interlayer according to the present invention between two transparent plate-like members and then heating and pressurizing the members can be used.

Among these, as the method of manufacturing the laminated glass according to the present invention, a method in which a nip roll method and an autoclave method are combined or a method in which a vacuum bag method and an autoclave method are combined is preferable.

In the method in which a nip roll method and an autoclave method are combined, for example, a laminate obtained by interposing the laminated glass interlayer according to the present invention between two transparent plate-like members is temporarily pressure-bonded by a nip roll, and then the laminate is heated and pressurized using an autoclave for thermal compression bonding to obtain the laminated glass.

In the method in which a vacuum bag method and an autoclave method are combined, for example, a laminate obtained by interposing the laminated glass interlayer according to the present invention between two transparent plate-like members is put into a vacuum bag, the laminate is temporarily pressure-bonded by reducing the pressure in the vacuum bag, and then the laminate is heated and pressurized using an autoclave for thermal compression bonding to obtain the laminated glass.

The laminated glass according to the present invention can be used for various uses, and for example, laminated glass for construction, laminated glass for automobiles, general buildings, agricultural buildings, or railway windows. However, the present invention is not limited to these uses.

### 4. Solar Cell Encapsulant

The solar cell encapsulant according to the present invention includes an adhesive resin layer including the adhesive resin composition according to the present disclosure.

A layer configuration and a preferable aspect of each of the layers in the solar cell encapsulant according to the present invention are the same as those of the laminated glass interlayer according to the present invention, and thus the description thereof will not be repeated.

In addition, the solar cell encapsulant according to the present invention can be manufactured using the same manufacturing method as that of the laminated glass interlayer according to the present invention.

### 5. Solar Cell Module

The solar cell module according to the present invention includes: a solar cell element, and an encapsulating resin layer that is formed of the solar cell encapsulant according to the present invention to encapsulate the solar cell element. Since the solar cell module according to the present invention includes the encapsulating resin layer formed of the solar cell encapsulant according to the present invention, the transparency and interlayer adhesiveness are improved.

The solar cell module according to the present invention may optionally further include a substrate on which sunlight is incident, a protective material, and the like. The substrate on which sunlight is incident will also be simply referred to as the substrate.

Regarding the solar cell module according to the present invention, for example, the solar cell element is interposed between the solar cell encapsulants, and these members are further interposed between the substrate and the protective material to prepare a laminate. Next, the laminate is heated and pressurized to bond the individual members. As a result, the solar cell module can be prepared.

As the solar cell module, various types of solar cell modules can be exemplified. Examples of the solar cell module include: a solar cell module having a configuration in which the substrate, the encapsulant, the solar cell element, the encapsulant, and the protective material are laminated in this order and are interposed between the encapsulants from both sides of the solar cell element; a solar cell module having a configuration where the solar cell element is formed in advance on the surface of the substrate such as glass and the substrate, the solar cell element, the encapsulant, and the protective material are laminated in this order; and a solar cell module having a configuration in which the encapsulant and the protective material are formed on the solar cell element formed on an inner peripheral surface of the substrate, for example, an amorphous solar cell element prepared on a fluororesin-based sheet by sputtering.

Assuming that the substrate on which sunlight is incident is the upper part of the solar cell module, the protective material is provided on a side of the solar cell module opposite to the substrate side, that is, in the lower part. Therefore, the protective material will also be referred to as a lower protective material or back surface protective material.

As the solar cell element, various solar cell elements, for example, a silicon-based solar cell element such as single crystal silicon, polycrystalline silicon, or amorphous silicon; a Group III-V or Group II-VI compound semiconductor-based solar cell element such as gallium-arsenic, copper-indium-selenium, copper-indium-gallium-selenium, or cadmium-tellurium; or a heterojunction-type solar cell element of amorphous silicon and single crystal silicon can be used.

In the solar cell module, a plurality of the solar cell elements are electrically connected in series through interconnectors, for example.

The solar cell module according to the present invention includes, for example, a metal material provided adjacent to the encapsulating resin layer. The metal material is, for example, a wiring or an electrode.

Examples of the metal material include a bus bar electrode, an interconnector, and a finger electrode.

The bus bar electrode, the interconnector, and the finger electrode are used as a module to join the solar cell elements to each other or to store generated electricity.

The metal material includes, for example, at least one metal selected from copper, tin, lead, iron, bismuth, aluminum, and silver.

Examples of the substrate forming the solar cell module according to the present invention include a glass substrate, an acrylic resin substrate, a polycarbonate substrate, a polyester substrate, a fluorine-containing resin substrate, and the like.

The protective material (lower protective material) is a single sheet or a multilayer sheet of metal, various inorganic materials, various thermoplastic resin films, or the like, and examples thereof include a sheet including a single layer or multiple layers formed of metal such as tin, aluminum, or stainless steel; an inorganic material such as glass; or a thermoplastic resin film such as polyester, inorganic deposited polyester, a fluorine-containing resin, or polyolefin. The solar cell encapsulant according to the present invention exhibits favorable adhesiveness to the substrate or the protective material.

A method of manufacturing the solar cell module according to the present invention is not particularly limited, and for example, a well-known manufacturing method in the related art such as a nip roll method, an autoclave method, a vacuum bag method, or a vacuum laminator method can be used. These manufacturing methods may be used alone or in combination of two or more kinds thereof for manufacturing.

Among these, as the method for manufacturing the solar cell module according to the present invention, a manufacturing method using a vacuum laminator is preferable.

In the method using a vacuum laminator, for example, a laminate obtained by interposing the solar cell encapsulant and the solar cell element according to the present invention between the substrate and the protective material is heated and vacuum-degassed in a double vacuum apparatus, and the laminate is heated and pressurized with diaphragm rubber from the upper part of the double vacuum apparatus for thermal compression bonding from in a pressurization step. As a result, the solar cell module is obtained.

Hereinabove, the embodiment of the present invention has been described. However, the embodiment is merely an example of the present invention, and various configurations other than the above-described configurations can also be adopted as far as not departing from the independent claims.

### Examples

Hereinafter, the present embodiment will be described in detail with reference to Examples and the like. It should be noted that the present embodiment is not limited to the descriptions of these examples.

### [Materials]

As each of components the following materials were used. Here, a melt flow rate (MFR) was measured under conditions of 190°C and a load of 2160 g according to JIS K 7210:1999. A Vicat softening point was measured according to JIS K 7206:1999.

### <Ethylene-Unsaturated Ester Copolymer (A)>

· EVA 1: an ethylene-vinyl acetate copolymer (the content of a constituent unit derived from ethylene: 67 mass%, the content of a constituent unit derived from vinyl acetate: 33 mass%, MFR (190°C, a load of 2160 g): 14 g/10 min)
· EVA 2: an ethylene-vinyl acetate copolymer (the content of a constituent unit derived from ethylene: 72 mass%, the content of a constituent unit derived from vinyl acetate: 28 mass%, MFR (190°C, a load of 2160 g): 15 g/10 min)
· EVA 3: an ethylene-vinyl acetate copolymer (the content of a constituent unit derived from ethylene: 81 mass%, the content of a constituent unit derived from vinyl acetate: 19 mass%, MFR (190°C, a load of 2160 g): 15 g/10 min)
· EVA 4: an ethylene-vinyl acetate copolymer (the content of a constituent unit derived from ethylene: 81 mass%, the content of a constituent unit derived from vinyl acetate: 19 mass%, MFR (190°C, a load of 2160 g): 150 g/10 min)

The content of the constituent unit derived from vinyl acetate was measured according to JIS K 7192:1999. The content of the constituent unit derived from ethylene was obtained by subtracting the content of the constituent unit derived from vinyl acetate from 100 mass% as the total content of the constituent unit derived from ethylene and the constituent unit derived from vinyl acetate.

### <Epoxy Group-Containing Ethylene-Based Copolymer (B)>

· EMAGMA 1: an ethylene-methyl acrylate-glycidyl methacrylate copolymer (the content of a constituent unit derived from ethylene: 67 mass%, the content of a constituent unit derived from methyl acrylate: 27 mass%, the content of a constituent unit derived from glycidyl methacrylate: 6 mass%, BONDFAST 7M (trade name), manufactured by Sumitomo Chemical Co., Ltd., MFR (190°C, load of 2160 g): 7 g/10 min), melting point: 52°C, Vicat softening point: lower than 25°C)
· EMAGMA 2: an ethylene-methyl acrylate-glycidyl methacrylate copolymer (the content of a constituent unit derived from ethylene: 70 mass%, the content of a constituent unit derived from methyl acrylate: 27 mass%, the content of a constituent unit derived from glycidyl methacrylate: 3 mass%, BONDFAST 7L (trade name), manufactured by Sumitomo Chemical Co., Ltd., MFR (190°C, load of 2160 g): 7 g/10 min), melting point: 60°C, Vicat softening point: lower than 25°C)
· EVAGMA 1: an ethylene-vinyl acetate-glycidyl methacrylate copolymer (the content of a constituent unit derived from ethylene: 83 mass%, content of a constituent unit derived from vinyl acetate: 5 mass%, the content of a constituent unit derived from glycidyl methacrylate: 12 mass%, BONDFAST 7B (trade name), manufactured by Sumitomo Chemical Co., Ltd., MFR (190°C, load of 2160 g) : 7 g/10 min), melting point: 95°C, Vicat softening point: 66°C)

In addition, the melting point of the epoxy group-containing ethylene-based copolymer (B) was measured according to JIS K 7121 :1987.

### <Silane coupling agent>

· Silane coupling agent 1:
   3-methacryloxypropyltrimethoxysilane (KBM503 (trade name), manufactured by Shin-Etsu Chemical Co., Ltd.)

### <Organic peroxide>

· Organic peroxide 1: 2,5-dimethyl-2,5-di(t-butylperoxy)hexane (LUPEROX 101 (trade name), manufactured by ARKEMA Yoshitomi, Ltd.)

### <Ionomer (C)>

· Ionomer 1: an Mg ionomer of an ethylene-methacrylic acid copolymer (the content of a constituent unit derived from ethylene: 80 mass%, the content of a constituent unit derived from methacrylic acid: 20 mass%, the degree of neutralization: 44%, MFR (190°C, load of 2160 g): 2.5 g/10 min)

### [Examples 1 to 2 and Comparative Examples 1 to 3]

The components were mixed in advance at a blending ratio shown in Table 1, and the mixture was fed to a 30 mmφ single screw extruder (machine number: 53-103, manufactured by THERMOPLASTIC Co., Ltd.) equipped with a pelletizer, and was melt-kneaded under the following extrusion conditions or melt-kneading conditions and granulated to obtain a pellet of an adhesive resin composition. The extrusion conditions of the single screw extruder are as follows.
L/D: 28
Barrel temperature (°C): C1 (80), C2 (115), C3 (135), C4 (135), C5 (135), D (130)
Screw rotation speed: 45 rpm
Extrusion amount: 3.5 kg/h
Screen mesh: 60/120/60

### [Examples 3 and 4]

The components were mixed in advance at a blending ratio shown in Table 1, and the mixture was fed to a 40 mmφ single screw extruder (machine number: VSK40, manufactured by NAKATANI Corporation) equipped with a pelletizer, and was melt-kneaded under the following extrusion conditions or melt-kneading conditions and granulated to obtain a pellet of an adhesive resin composition. Here, the blending amount (parts by mass) of the silane coupling agent and the organic peroxide in Example 4 is a value with respect to 100 parts by mass of the total amount of the ethylene-unsaturated ester copolymer (A) and the epoxy group-containing ethylene-based copolymer (B). The silane coupling agent and the organic peroxide were impregnated in the ethylene-unsaturated ester copolymer (A) and the epoxy group-containing ethylene-based copolymer (B), and then were melt-kneaded. The extrusion conditions of the single screw extruder are as follows.
Screw: a tip of a Dulmage screw
L/D: 28
Barrel temperature (°C); C1 (120), C2 (160), C3 (180), C4 (200), D (160)
Screw rotation speed: 45 rpm
Extrusion amount: 10 kg/h
Screen mesh: 60/120/60

### <Evaluation of Optical Characteristics of Adhesive Resin Composition>

### (1) Preparation of Sheet

The obtained adhesive resin composition was pressed using a hydraulic heat press machine (machine number: TBDM50-2, manufactured by Toho machinery Co., Ltd.) under conditions of 140°C and 9.8 MPa, and then was cooled under conditions of 20°C and 14.7 MPa to prepare a press sheet having a thickness of 3 mm.

### (2) Measurement of Haze

Using the obtained press sheet, the haze was measured with a haze meter (product name: HZ-V3 type, manufactured by Suga Test Instruments Co., Ltd.) according to JIS K 7136:2000. The haze was evaluated based on the following standard. The evaluation results are shown in Table 1.

### (Evaluation Standards of Haze)

A (excellent): the haze was 10% or less
B (good): the haze was more than 10% and 20% or less
C (bad): the haze was more than 20%

### (3) Measurement of Total Light Transmittance

Using the obtained press sheet, the total light transmittance was measured with a haze meter (product name: HZ-V3 type, manufactured by Suga Test Instruments Co., Ltd.) according to JIS K 7361-1:1997. The total light transmittance was evaluated according to the following standard. The evaluation results are shown in Table 1.

### (Evaluation Standards of Total Light Transmittance)

In the evaluation of the press sheet having a thickness of 3 mm prepared using the above-described method,
A (excellent): the total light transmittance was 90% or more
B (good) : the total light transmittance was 70% or more and less than 90%
C (bad): the total light transmittance was less than 70%.

### (3) Measurement of Yellow Index (YI)

Using the obtained press sheet, YI (transmission method) was measured using a color meter (CC-iS, manufactured by Suga Test Instruments Co., Ltd.) in accordance with JIS K 7373:2006. YI was evaluated based on the following standards. The evaluation results are shown in Table 1.

### (Evaluation Standards of YI)

A (excellent): YI was 3 or less
B (good): YI was more than 3 and 5 or less
C (bad): YI was more than 5

### [Table 1]

**Table 1**

| | | Example 1 | Example 2 | Example 3 | Example 4 | Comparative Example 1 | Comparative Example 2 | Comparative Example 3 |
|---|---|---|---|---|---|---|---|---|
| Ethylene-Unsaturated Ester Copolymer (A) | EVA 1 [mass%] | 90 | 90 | 50 | 50 | 90 | | |
| | EVA 2 [mass%] | | | | | | 90 | |
| | EVA 3 [mass%] | | | | | | | 90 |
| Epoxy Group-Containing Ethylene-Based Copolymer (B) | EMAGMA 1 [mass%] | 10 | | 50 | 50 | | | |
| | EMAGMA 2 [mass%] | | 10 | | | | | |
| | EVAGMA 1 [mass%] | | | | | 10 | 10 | 10 |
| Silane Coupling Agent [Part(s) by Mass] | | | | | 1.5 | | | |
| Organic Peroxide [Part(s) by Mass] | | | | | 0.3 | | | |
| Content of Unit Derived from Unsaturated Ester in Copolymer (A) [mass%] | | 33 | 33 | 33 | 33 | 33 | 28 | 19 |
| Content (X₁) of Unit Derived from Ethylene in Copolymer (A) [mass%] | | 67 | 67 | 67 | 67 | 67 | 72 | 81 |
| Content (X₂) of Unit Derived from Ethylene in Copolymer (B) [mass%] | | 67 | 70 | 67 | 67 | 83 | 83 | 83 |
| Absolute Value of Ethylene Content Difference (X₁ - X₂) [mass%] | | 0 | 3 | 0 | 0 | 16 | 11 | 2 |
| Evaluation Result | Haze [%] | 4.1 | 4.1 | 8.4 | 8.2 | 90.5 | 26.6 | 19.7 |
| | | A | A | A | A | C | C | B |
| | Total Light Transmittance [%] | 91.1 | 90.9 | 90.4 | 90.3 | 68.0 | 76.2 | 79.8 |
| | | A | A | A | A | C | B | B |
| | YI | 1.1 | 1.2 | 2.2 | 2.3 | 9.8 | 9.8 | 8.8 |
| | | A | A | A | A | C | C | C |

As clear seen from Table 1, in the press sheets prepared using the adhesive resin compositions of Examples 1 to 4, all of the haze, the total light transmittance, and YI were excellent, and the transparency was excellent. On the other hand, in the press sheet prepared using the adhesive resin composition according to Comparative Example 1 where the ethylene content difference was 16 mass%, all of the haze, the total light transmittance, and YI were bad, and the transparency was poor. On the other hand, in the press sheet prepared using the adhesive resin composition according to Comparative Example 2 where the ethylene content difference was 11 mass%, the haze and YI were bad, and the transparency was poor. In the press sheet prepared using the adhesive resin composition according to Comparative Example 3 where the content of the unsaturated ester of the ethylene-unsaturated ester copolymer was less than 20 mass%, YI was bad, and the transparency was poor.

It was able to be verified from the above results that the transparency can be improved with the adhesive resin composition according to the present invention.

### [Examples 5 and 6 and Comparative Examples 4 and 5]

The adhesive resin composition obtained in Example 3 was set as an adhesive resin composition 1.

The adhesive resin composition obtained in Example 4 was set as an adhesive resin composition 2.

EVA 3: 25 mass%, EVA 4: 25 mass%, EVAGMA 1: 50 mass%, the silane coupling agent: 1.5 parts by mass, and the organic peroxide: 0.3 parts by mass were mixed in advance, and the mixture was fed to a 40 mmφ single screw extruder (manufactured by NAKATANI Corporation) equipped with a pelletizer, and was melt-kneaded under the following extrusion conditions or melt-kneading conditions and granulated to obtain a pellet of an adhesive resin composition. Here, the blending amount (parts by mass) of the silane coupling agent and the organic peroxide is a value with respect to 100 parts by mass of the total amount of the ethylene-unsaturated ester copolymer (A) and the epoxy group-containing ethylene-based copolymer (B). The extrusion conditions of the single screw extruder are as follows. The obtained adhesive resin composition was set as an adhesive resin composition 3.
Screw: a tip of a Dulmage screw
L/D: 28
Barrel temperature (°C); C1 (120), C2 (160), C3 (180), C4 (200), D (160)
Screw rotation speed: 45 rpm
Extrusion amount: 10 kg/h
Screen mesh: 60/120/60

The components were mixed in advance at a blending ratio shown in Table 2, and the mixture was fed to a 40 mmφ T-die sheet molding machine (machine number: VSK40, manufactured by NAKATANI Corporation), was melt-kneaded under the following extrusion conditions or melt-kneading conditions, and was extruded into a sheet, to prepare sheets having thicknesses of 100 µm and 300 µm and formed of an adhesive resin composition, respectively. The extrusion conditions of the T-die sheet molding machine are as follows.
Screw: a tip of a Dulmage double flighted screw
L/D: 26
Barrel temperature (°C); C1 (80), C2 (100), C3 (120), A (120), D1 (120), D2 (120), D3 (120)
Screw rotation speed: 45 rpm
Screen mesh: 60

### <Evaluation of Optical Characteristics of Glass Laminate>

### (1) Preparation of Glass Laminate

Using a vacuum heating bonding machine (double vacuum chamber bonding machine, product name: LM-50 × 50S, manufactured by NPC Incorporated), the glass, the ionomer 1, the sheet formed of the adhesive resin composition having a thickness of 100 µm, and the glass were laminated in this order, and were bonded to each other at a heating temperature of 140°C, a pressure of 1 atm during heating, and a heating time of 20 minutes. Next, the laminate was wrapped with bleached cloth, was left to stand in the atmosphere and was slowly cooled by natural cooling to prepare a glass laminate for optical characteristics evaluation.

Configuration of the glass laminate: glass (3.2 mm thick)/ionomer 1 (1500 µm thick)/sheet (100 µm thick) formed of adhesive resin composition/glass (3.2 mm thick)

### (2) Measurement of Haze

Using the obtained glass laminate, the haze was measured with a haze meter (product name: HZ-V3 type, manufactured by Suga Test Instruments Co., Ltd.) according to JIS K 7136:2000. The haze was evaluated based on the following standard. Table 2 shows the evaluation results.

### (Evaluation Standards of Haze)

A (excellent): the haze was 5% or less
B (good): the haze was more than 5% and 10% or less
C (bad): the haze was more than 10%

### (3) Measurement of total light transmittance

Using the obtained glass laminate, the total light transmittance was measured with a haze meter (product name: HZ-V3 type, manufactured by Suga Test Instruments Co., Ltd.) according to JIS K 7361-1:1997. The total light transmittance was evaluated according to the following standard. Table 2 shows the evaluation results.

### (Evaluation Standards of Total Light Transmittance)

A (excellent): the total light transmittance was 85% or more
B (good) : the total light transmittance was 80% or more and less than 85%
C (bad): the total light transmittance was less than 80%.

### (4) Measurement of Yellow Index (YI)

Using the obtained glass laminate, YI (transmission method) was measured using a color meter (CC-iS, manufactured by Suga Test Instruments Co., Ltd.) in accordance with JIS K 7373:2006. YI was evaluated based on the following standards. Table 2 shows the evaluation results.

### (Evaluation Standards of YI)

A (excellent): YI was 3 or less
B (good): YI was more than 3 and 5 or less
C (bad): YI was more than 5

### <Adhesiveness Evaluation to PET Film>

Using a vacuum heating bonding machine (double vacuum chamber bonding machine, product name: LM-50 × 50S, manufactured by NPC Incorporated), glass (a non-tin surface is an adhesive surface), a sheet having a thickness of 300 µm and formed of the adhesive resin composition, and a PET film (non-corona treated) having a thickness of 100 µm were laminated in this order and were bonded at a heating temperature of 140°C and a pressure of 1 atm during heating for a heating time of 60 minutes to prepare a glass laminate. Subsequently the glass laminate was left to stand in the atmosphere and was slowly cooled by natural cooling.

Configuration of the glass laminate: glass (3.9 mm thick) /sheet (300 µm thick) formed of adhesive resin composition/PET film (100 mm thick)
A slit having a width of 15 mm was formed in a sheet portion of the obtained glass laminate to obtain a test piece, and the test piece was provided in a tensile tester. A PET film was peeled off at a tension rate of 100 mm/min and a peel angle of 180° and an average stress was obtained as an initial stage adhesive strength (N/15 mm) .

The glass laminate was stored under conditions of 85°C and a relative humidity of 90% to obtain an adhesive strength of the glass laminate after the storage for 500 hours and an adhesive strength of the glass laminate after the storage for 1000 hours, respectively. The obtained adhesive strength was defined as the adhesive strength of the each of the glass laminates to the PET film. The adhesiveness to the PET film was evaluated based on the following standards. The measurement results are shown in Table 2.

### (Evaluation Standards of Adhesiveness to PET Film)

A (excellent): all of the adhesive strength to the PET film at an initial stage, after 500 hours, and after 1000 hours were 15 N/15 mm or more
B (bad): one or more of the adhesive strength to the PET film at an initial stage, after 500 hours, and after 1000 hours were less than 15 N/15 mm

### <Adhesiveness Evaluation to Glass>

Using a vacuum heating bonding machine (double vacuum chamber bonding machine, product name: LM-50 × 50S, manufactured by NPC Incorporated), glass (a non-tin surface is an adhesive surface), and a sheet having a thickness of 300 µm and formed of the adhesive resin composition were laminated in this order and were bonded at a heating temperature of 140°C and a pressure of 1 atm during heating for a heating time of 60 minutes to prepare a glass laminate. Subsequently the glass laminate was left to stand in the atmosphere and was slowly cooled by natural cooling.

### Configuration of the glass laminate: glass (3.9 mm thick) /sheet (300 µm thick) formed of adhesive resin composition

A slit having a width of 15 mm was formed in a sheet portion of the obtained glass laminate to obtain a test piece, and the test piece was provided in a tensile tester. The glass (3.9 mm thick) and the sheet (300 µm thick) formed of the adhesive resin composition were peeled off from each other at a tension rate of 100 mm/min and a peel angle of 180°, and an average stress was obtained as an initial stage adhesive strength (N/15 mm).

The glass laminate was stored under conditions of 85°C and a relative humidity of 90% to obtain an adhesive strength of the glass laminate after the storage for 500 hours and an adhesive strength of the glass laminate after the storage for 1000 hours, respectively. The obtained adhesive strength was defined as the adhesive strength of the each of the glass laminates to the glass. The adhesiveness to glass was evaluated based on the following standards. The measurement results are shown in Table 2.

### (Evaluation Standards of Adhesiveness to Glass)

A (excellent) : all of the adhesive strength to glass at an initial stage, after 500 hours, and after 1000 hours were 20 N/15 mm or more
B (bad): one or more of the adhesive strength to glass at an initial stage, after 500 hours, and after 1000 hours were less than 20 N/15 mm

### [Table 2]

**Table 2**

| | | Example 5 | Example 6 | Comparative Example 4 | Comparative Example 5 |
|---|---|---|---|---|---|
| Ethylene-Unsaturated Ester Copolymer (A) | EVA 1 [mass%] | 90 | 90 | 90 | 100 |
| Adhesive Resin Composition | Adhesive Resin Composition 1 | 10 | | | |
| | Adhesive Resin Composition 2 | | 10 | | |
| | Adhesive Resin Composition 3 | | | 10 | |
| Content of Unit Derived from Unsaturated Ester in Copolymer (A) [mass%] | | 33 | 33 | 32.3 | 33 |
| Content (X₁) of Unit Derived from Ethylene in Copolymer (A) [mass%] | | 67 | 67 | 67.7 | 67 |
| Content (X₂) of Unit Derived from Ethylene in Copolymer (B) [mass%] | | 67 | 67 | 83 | - |
| Absolute Value of Ethylene Content Difference (X₁ - X₂) [mass%] | | 0 | 0 | 15.3 | - |
| Evaluation Result | Haze [%] | 2.9 | 3.0 | 23.9 | 2.9 |
| | | A | A | C | A |
| | Total Light Transmittance [%] | 89.8 | 89.2 | 91.9 | 89.7 |
| | | A | A | A | A |
| | YI | 1.7 | 1.7 | 1.6 | 1.6 |
| | | A | A | A | A |
| Adhesive Strength to PET Film [N/15 mm] (Non-Corona Treated Surface) | Initial Stage | 20.4 | 22.0 | 20.3 | 9.3 |
| | After 500 Hours | 49.5 (Material Damaged) | 148.5 (Material Damaged) | 59.7 | 12.6 |
| | After 1000 Hours | 89.6 (Material Damaged) | 144.4 (Material Damaged) | 47.5 | 10.3 |
| | | A | A | A | B |
| Adhesive Strength to Glass [N/15 mm] (Non-Tin Surface) | Initial Stage | 74.6 (Material Damaged) | 106.3 (Material Damaged) | 38.7 | 0.5 |
| | After 500 Hours | 97.9 (Material Damaged) | 116.2 (Material Damaged) | 27.5 | Not Adhered |
| | After 1000 Hours | 25.4 | 94.5 (Material Damaged) | 48.9 | Not Adhered |
| | | A | A | A | B |

As clear seen from Table 2, in the laminated glass laminate prepared using the adhesive resin compositions of Examples 5 and 6, all of the haze, the total light transmittance, and YI were excellent, and the transparency was excellent. Further, the adhesiveness to the PET film and the adhesiveness to glass were also excellent. On the other hand, in the glass laminate prepared using the adhesive resin composition according to Comparative Example 4 where the ethylene content difference was 15.3 mass%, the haze was bad, and the transparency was poor. In the glass laminate prepared using the adhesive resin composition according to Comparative Example 5 not including the epoxy group-containing ethylene-based copolymer (B), the adhesiveness to the PET film and the adhesiveness to glass were bad, and the adhesiveness was poor.

It was able to be verified from the above results that the transparency and the adhesiveness to the polyester resin layer can be improved with the adhesive resin composition according to the present invention.

This glass laminate can be used for, for example, the laminated glass or the solar cell module.

## Claims

1. A laminated glass interlayer comprising, in the following order:
an ionomer resin layer that includes an ionomer (C) of an ethylene-unsaturated carboxylic acid-based copolymer;
an adhesive resin layer that includes an adhesive resin composition; and
a polyester resin layer that includes a polyester resin (D);
the adhesive resin composition comprising:
an ethylene-unsaturated ester copolymer (A); and
an epoxy group-containing ethylene-based copolymer (B) (other than the ethylene-unsaturated ester copolymer (A)),
wherein a content of a constituent unit derived from an unsaturated ester in the ethylene-unsaturated ester copolymer (A) is more than 20 mass% with respect to all constituent units forming the ethylene-unsaturated ester copolymer (A), and
an absolute value of a difference (X₁ - X₂) between a content (X₁) of a constituent unit derived from ethylene with respect to all the constituent units forming the ethylene-unsaturated ester copolymer (A) and a content (X₂) of a constituent unit derived from ethylene with respect to all constituent units forming the epoxy group-containing ethylene-based copolymer (B) is 10 mass% or less.

2. The laminated glass interlayer according to Claim 1,
wherein the ethylene-unsaturated ester copolymer (A) includes an ethylene-vinyl acetate copolymer.

3. The laminated glass interlayer according to Claim 1 or Claim 2,
wherein the epoxy group-containing ethylene-based copolymer (B) includes at least one kind selected from the group consisting of an ethylene-glycidyl (meth)acrylate copolymer, an ethylene-glycidyl (meth)acrylate-vinyl acetate copolymer, and an ethylene-glycidyl (meth)acrylate-(meth)acrylic acid ester copolymer.

4. The laminated glass interlayer according to any one of Claims 1 to 3,
wherein the content of the constituent unit derived from ethylene in the epoxy group-containing ethylene-based copolymer (B) is 82 mass% or less with respect to all the constituent units forming the epoxy group-containing ethylene-based copolymer (B).

5. The laminated glass interlayer according to any one of Claims 1 to 4,
wherein a haze measured using the following method is 10% or less,
(Method)
the adhesive resin composition is pressed under conditions of 140°C and 9.8 MPa and is subsequently cooled under conditions of 20°C and 14.7 MPa to prepare a press sheet having a thickness of 3 mm, and
subsequently a haze of the obtained press sheet is measured by a haze meter according to JIS K 7136:2000.

6. The laminated glass interlayer according to any one of Claims 1 to 5,
wherein when a total content of the ethylene-unsaturated ester copolymer (A) and the epoxy group-containing ethylene-based copolymer (B) is represented by 100 mass%, a content of the ethylene-unsaturated ester copolymer (A) is 40 mass% or more and 99 mass% or less.

7. The laminated glass interlayer according to any one of Claims 1 to 6,
wherein when a total content of the adhesive resin composition is represented by 100 mass%, a total content of the ethylene-unsaturated ester copolymer (A) and the epoxy group-containing ethylene-based copolymer (B) is 70 mass% or more and 100 mass% or less.

8. The laminated glass interlayer according to any one of Claims 1 to 7,
wherein a haze measured using the following method is 5% or less,
(Method)
glass having a thickness of 3.2 mm, an ionomer resin layer having a thickness of 1500 µm, a sheet having a thickness of 100 µm and formed of the adhesive resin composition, and glass having a thickness of 3.2 mm are laminated in this order and are bonded at a heating temperature of 140°C and a pressure of 1 atm during heating for a heating time of 20 minutes,
the obtained laminate is slowly cooled by natural cooling to prepare a glass laminate for optical characteristics evaluation, and
subsequently a haze of the obtained glass laminate is measured by a haze meter according to JIS K 7136:2000.

9. The laminated glass interlayer according to any one of Claims 1 to 8,
wherein all adhesive strengths to a PET film measured at an initial stage, after 500 hours, and after 1000 hours using the following method are 15 N/15 mm or more,
(Method)
glass having a thickness of 3.9 mm (a non-tin surface is an adhesive surface), a sheet having a thickness of 300 µm and formed of the adhesive resin composition, and a PET film (non-corona treated) having a thickness of 100 µm are laminated in this order and are bonded at a heating temperature of 140°C and a pressure of 1 atm during heating for a heating time of 60 minutes to prepare a glass laminate,
subsequently the glass laminate is left to stand in the atmosphere and is slowly cooled by natural cooling,
a slit having a width of 15 mm is formed in a sheet portion of the obtained glass laminate to obtain a test piece and the test piece is provided in a tensile tester,
a PET film is peeled off at a tension rate of 100 mm/min and a peel angle of 180° and an average stress is obtained as an initial stage adhesive strength (N/15 mm), and
the glass laminate is stored under conditions of 85°C and a relative humidity of 90% to obtain an adhesive strength of the glass laminate after the storage for 500 hours and an adhesive strength of the glass laminate after the storage for 1000 hours, respectively.

10. The laminated glass interlayer according to any one of Claims 1 to 9,
wherein an adhesive strength to a PET film measured after the storage of 1000 hours using the following method is 50 N/15 mm or more,
(Method)
glass having a thickness of 3.9 mm (a non-tin surface is an adhesive surface), a sheet having a thickness of 300 µm and formed of the adhesive resin composition, and a PET film (non-corona treated) having a thickness of 100 µm are laminated in this order and are bonded at a heating temperature of 140°C and a pressure of 1 atm during heating for a heating time of 60 minutes to prepare a glass laminate,
subsequently the glass laminate is left to stand in the atmosphere and is slowly cooled by natural cooling,
subsequently the glass laminate is stored under conditions of 85°C and a relative humidity of 90% for 1000 hours,
a slit having a width of 15 mm is formed in a sheet portion of the obtained glass laminate to obtain a test piece and the test piece is provided in a tensile tester, and
a PET film is peeled off at a tension rate of 100 mm/min and a peel angle of 180° and an average stress is obtained as an adhesive strength (N/15 mm) to the PET film after the storage for 1000 hours.

11. The laminated glass interlayer according to any one of Claims 1 to 10,
wherein the ionomer resin layer and the adhesive resin layer are adjacent to each other, and
the polyester resin layer is adjacent to a surface of the adhesive resin layer opposite to a surface adjacent to the ionomer resin layer.

12. A laminated glass comprising:
the laminated glass interlayer according to any one of Claims 1 to 11; and
a transparent plate-like member that is provided on both surfaces of the laminated glass interlayer.

13. The laminated glass according to Claim 12, comprising:
at least one configuration where the transparent plate-like member and the ionomer resin layer are adjacent to each other.

14. A solar cell encapsulant comprising, in the following order:
an ionomer resin layer that includes an ionomer (C) of an ethylene-unsaturated carboxylic acid-based copolymer;
an adhesive resin layer that includes an adhesive resin composition; and
a polyester resin layer that includes a polyester resin (D),
the adhesive resin composition comprising:
an ethylene-unsaturated ester copolymer (A); and
an epoxy group-containing ethylene-based copolymer (B) (other than the ethylene-unsaturated ester copolymer (A)),
wherein a content of a constituent unit derived from an unsaturated ester in the ethylene-unsaturated ester copolymer (A) is more than 20 mass% with respect to all constituent units forming the ethylene-unsaturated ester copolymer (A), and
an absolute value of a difference (X₁ - X₂) between a content (X₁) of a constituent unit derived from ethylene with respect to all the constituent units forming the ethylene-unsaturated ester copolymer (A) and a content (X₂) of a constituent unit derived from ethylene with respect to all constituent units forming the epoxy group-containing ethylene-based copolymer (B) is 10 mass% or less.

15. A solar cell module comprising:
a solar cell element; and
an encapsulating resin layer that is formed of the solar cell encapsulant according to Claim 14 to encapsulate the solar cell element.

## Patentansprüche

1. Verbundglaszwischenschicht, umfassend, in der folgenden Reihenfolge:
eine Ionomerharzschicht, die ein Ionomer (C) aus einem Copolymer auf Basis von Ethylen und einer ungesättigten Carbonsäure beinhaltet;
eine Haftharzschicht, die eine Haftharzzusammensetzung beinhaltet; und
eine Polyesterharzschicht, die ein Polyesterharz (D) beinhaltet;
wobei die Haftharzzusammensetzung umfasst:
ein Copolymer (A) aus Ethylen und einem ungesättigten Ester; und
ein epoxygruppenhaltiges Copolymer (B) auf Ethylenbasis (mit Ausnahme des Copolymers (A) aus Ethylen und einem ungesättigten Ester),
wobei ein Gehalt an einer Grundeinheit, die von einem ungesättigten Ester abgeleitet ist, in dem Copolymer (A) aus Ethylen und einem ungesättigten Ester mehr als 20 Masse-%, bezogen auf alle Grundeinheiten, die das Copolymer (A) aus Ethylen und einem ungesättigten Ester bilden, beträgt, und
ein Absolutwert einer Differenz (X₁ - X₂) zwischen einem Gehalt (X₁) an einer Grundeinheit, die von Ethylen abgeleitet ist, bezogen auf alle Grundeinheiten, die das Copolymer (A) aus Ethylen und einem ungesättigten Ester ausbilden, und einem Gehalt (X₂) an einer Grundeinheit, die von Ethylen abgeleitet ist, bezogen auf alle Grundeinheiten, die das epoxygruppenhaltige Copolymer (B) auf Ethylenbasis ausbilden, 10 Masse-% oder weniger beträgt.

2. Verbundglaszwischenschicht nach Anspruch 1,
wobei das Copolymer (A) aus Ethylen und einem ungesättigten Ester ein Ethylen-Vinylacetat-Copolymer beinhaltet.

3. Verbundglaszwischenschicht nach Anspruch 1 oder Anspruch 2,
wobei das epoxygruppenhaltige Copolymer (B) auf Ethylenbasis mindestens eine Art beinhaltet, die ausgewählt ist aus der Gruppe bestehend aus einem Ethylen-Glycidyl(meth)acrylat-Copolymer, einem Ethylen-Glycidyl(meth)acrylat-Vinylacetat-Copolymer und einem Ethylen-Glycidyl(meth)acrylat-(Meth)acrylsäureester-Copolymer.

4. Verbundglaszwischenschicht nach einem der Ansprüche 1 bis 3,
wobei der Gehalt an der Grundeinheit, die von Ethylen abgeleitet ist, in dem epoxidgruppenhaltigen Copolymer (B) auf Ethylenbasis 82 Masse-% oder weniger, bezogen auf alle Grundeinheiten, die das epoxidgruppenhaltige Copolymer (B) auf Ethylenbasis ausbilden, beträgt.

5. Verbundglaszwischenschicht nach einem der Ansprüche 1 bis 4,
wobei eine unter Verwendung des folgenden Verfahrens gemessene Trübung 10 % oder weniger beträgt,
(Verfahren)
die Haftharzzusammensetzung wird unter Bedingungen von 140 °C und 9,8 MPa gepresst und anschließend unter Bedingungen von 20 °C und 14,7 MPa abgekühlt, um eine Pressplatte, die eine Dicke von 3 mm aufweist, herzustellen, und
anschließend wird eine Trübung der erhaltenen Pressplatte mit einem Trübungsmessgerät gemäß JIS K 7136:2000 gemessen.

6. Verbundglaszwischenschicht nach einem der Ansprüche 1 bis 5,
wobei, wenn ein Gesamtgehalt an dem Copolymer (A) aus Ethylen und einem ungesättigten Ester und dem epoxidgruppenhaltigen Copolymer (B) auf Ethylenbasis mit 100 Masse-% angegeben ist, ein Gehalt an dem Copolymer (A) aus Ethylen und einem ungesättigten Ester 40 Masse-%t oder mehr und 99 Masse-% oder weniger beträgt.

7. Verbundglaszwischenschicht nach einem der Ansprüche 1 bis 6,
wobei, wenn ein Gesamtgehalt an der Haftharzzusammensetzung mit 100 Masse-% angegeben ist, ein Gesamtgehalt an dem Copolymer (A) aus Ethylen und einem ungesättigten Ester und dem epoxidgruppenhaltigen Copolymer (B) auf Ethylenbasis 70 Masse-% oder mehr und 100 Masse-% oder weniger beträgt.

8. Verbundglaszwischenschicht nach einem der Ansprüche 1 bis 7,
wobei eine unter Verwendung des folgenden Verfahrens gemessene Trübung 5 % oder weniger beträgt,
(Verfahren)
Glas, das eine Dicke von 3,2 mm aufweist, eine Ionomerharzschicht, die eine Dicke von 1500 µm aufweist, eine Platte, die eine Dicke von 100 µm aufweist und aus der Haftharzzusammensetzung ausgebildet ist, und Glas, das eine Dicke von 3,2 mm aufweist, werden in dieser Reihenfolge laminiert und bei einer Erwärmungstemperatur von 140 °C und einem Druck von 1 atm während einer Erwärmung für eine Erwärmungszeit von 20 Minuten miteinander verbunden,
das erhaltene Laminat wird durch natürliche Abkühlung langsam abgekühlt, um ein Glaslaminat für die Bewertung der optischen Eigenschaften herzustellen, und
anschließend wird eine Trübung des erhaltenen Glaslaminats mit einem Trübungsmessgerät gemäß JIS K 7136:2000 gemessen.

9. Verbundglaszwischenschicht nach einem der Ansprüche 1 bis 8,
wobei alle Haftfestigkeiten an einer PET-Folie, die in einer Anfangsphase, nach 500 Stunden und nach 1000 Stunden unter Anwendung des folgenden Verfahrens gemessen wurden, 15 N/15 mm oder mehr betragen,
(Verfahren)
Glas, das eine Dicke von 3,9 mm aufweist (eine zinnfreie Fläche ist eine Haftfläche), eine Platte, die eine Dicke von 300 µm aufweist und aus der Haftharzzusammensetzung ausgebildet ist, und eine PET-Folie (ohne Koronabehandlung), die eine Dicke von 100 µm aufweist, werden in dieser Reihenfolge laminiert und bei einer Erwärmungstemperatur von 140 °C und einem Druck von 1 atm während einer Erwärmung für eine Erwärmungszeit von 60 Minuten miteinander verbunden, um ein Glaslaminat herzustellen,
anschließend wird das Glaslaminat an der Luft stehengelassen und durch natürliche Abkühlung langsam abgekühlt,
in einem Plattenabschnitt des erhaltenen Glaslaminats wird ein Schlitz, der eine Breite von 15 mm aufweist, ausgebildet, um ein Prüfstück zu erhalten, und das Prüfstück wird einer Zugprüfmaschine zugeführt,
eine PET-Folie wird mit einer Zugrate von 100 mm/min und einem Abziehwinkel von 180° abgezogen, und eine durchschnittliche Spannung wird als Anfangsphasenhaftfestigkeit (N/15 mm) erhalten, und
das Glaslaminat wird unter Bedingungen von 85 °C und einer relativen Luftfeuchtigkeit von 90 % gelagert, um eine Haftfestigkeit des Glaslaminats nach der Lagerung über 500 Stunden bzw. eine Haftfestigkeit des Glaslaminats nach der Lagerung über 1000 Stunden zu erhalten.

10. Verbundglaszwischenschicht nach einem der Ansprüche 1 bis 9,
wobei eine Haftfestigkeit an einer PET-Folie, gemessen nach der Lagerung über 1000 Stunden, unter Verwendung des folgenden Verfahrens 50 N/15 mm oder mehr beträgt,
(Verfahren)
Glas, das eine Dicke von 3,9 mm aufweist (eine zinnfreie Fläche ist eine Haftfläche), eine Platte, die eine Dicke von 300 µm aufweist und aus der Haftharzzusammensetzung ausgebildet ist, und eine PET-Folie (ohne Koronabehandlung), die eine Dicke von 100 µm aufweist, werden in dieser Reihenfolge laminiert und bei einer Erwärmungstemperatur von 140 °C und einem Druck von 1 atm während einer Erwärmung für eine Erwärmungszeit von 60 Minuten miteinander verbunden, um ein Glaslaminat herzustellen,
anschließend wird das Glaslaminat an der Luft stehengelassen und durch natürliche Abkühlung langsam abgekühlt,
anschließend wird das Glaslaminat unter Bedingungen von 85 °C und einer relativen Luftfeuchtigkeit von 90 % für 1000 Stunden gelagert,
in einem Plattenabschnitt des erhaltenen Glaslaminats wird ein Schlitz, der eine Breite von 15 mm aufweist, ausgebildet, um ein Prüfstück zu erhalten, und das Prüfstück wird einer Zugprüfmaschine zugeführt, und
eine PET-Folie wird mit einer Zugrate von 100 mm/min und einem Abziehwinkel von 180° abgezogen und eine durchschnittliche Spannung wird als Haftfestigkeit (N/15 mm) an der PET-Folie nach der Lagerung für 1000 Stunden erhalten.

11. Verbundglaszwischenschicht nach einem der Ansprüche 1 bis 10,
wobei die Ionomerharzschicht und die Haftharzschicht benachbart zueinander sind und
die Polyesterharzschicht benachbart zu einer Fläche der Haftharzschicht ist, die einer Fläche gegenüberliegt, die benachbart zu der Ionomerharzschicht ist.

12. Verbundglas, umfassend:
die Verbundglaszwischenschicht nach einem der Ansprüche 1 bis 11; und
ein transparentes tafelähnliches Element, das auf beiden Flächen der Verbundglaszwischenschicht bereitgestellt ist.

13. Verbundglas nach Anspruch 12, umfassend:
mindestens eine Konfiguration, bei der das transparente, tafelähnliche Element und die Ionomerharzschicht benachbart zueinander sind.

14. Solarzelleneinkapselungsmittel, umfassend, in der folgenden Reihenfolge:
eine Ionomerharzschicht, die ein Ionomer (C) aus einem Copolymer auf Basis von Ethylen und einer ungesättigten Carbonsäure beinhaltet;
eine Haftharzschicht, die eine Haftharzzusammensetzung beinhaltet; und
eine Polyesterharzschicht, die ein Polyesterharz (D) beinhaltet,
wobei die Haftharzzusammensetzung umfasst:
ein Copolymer (A) aus Ethylen und einem ungesättigten Ester; und
ein epoxygruppenhaltiges Copolymer (B) auf Ethylenbasis (mit Ausnahme des Copolymers (A) aus Ethylen und einem ungesättigten Ester),
wobei ein Gehalt an einer Grundeinheit, die von einem ungesättigten Ester abgeleitet ist, in dem Copolymer (A) aus Ethylen und einem ungesättigten Ester mehr als 20 Masse-%, bezogen auf alle Grundeinheiten, die das Copolymer (A) aus Ethylen und einem ungesättigten Ester ausbilden, beträgt, und
ein Absolutwert einer Differenz (X₁ - X₂) zwischen einem Gehalt (X₁) an einer Grundeinheit, die von Ethylen abgeleitet ist, bezogen auf alle Grundeinheiten, die das Copolymer (A) aus Ethylen und einem ungesättigten Ester ausbilden, und einem Gehalt (X₂) an einer Grundeinheit, die von Ethylen abgeleitet ist, bezogen auf alle Grundeinheiten, die das epoxygruppenhaltige Copolymer (B) auf Ethylenbasis ausbilden, 10 Masse-% oder weniger beträgt.

15. Solarzellenmodul, umfassend:
ein Solarzellenelement; und
eine Einkapselungsharzschicht, die aus dem Solarzelleneinkapselungsmittel nach Anspruch 14 ausgebildet ist, um das Solarzellenelement einzukapseln.

## Revendications

1. Couche intermédiaire de verre feuilleté, comprenant, dans l'ordre suivant :
une couche de résine ionomère comprenant un ionomère (C) constitué d'un copolymère à base d'éthylène et d'acide carboxylique insaturé ;
une couche de résine adhésive comprenant une composition de résine adhésive ; et
une couche de résine de polyester comprenant une résine de polyester (D) ;
la composition de résine adhésive comprenant :
un copolymère d'éthylène et d'ester insaturé (A) ; et
un copolymère à base d'éthylène contenant des groupes époxy (B) (autre que le copolymère d'éthylène et d'ester insaturé (A)),
dans laquelle une teneur en unité constitutive dérivée d'un ester insaturé dans le copolymère d'éthylène et d'ester insaturé (A) est supérieure à 20 % en masse par rapport à toutes les unités constitutives formant le copolymère d'éthylène et d'ester insaturé (A), et
une valeur absolue d'une différence (X₁ - X₂) entre une teneur (X₁) en unité constitutive dérivée d'éthylène par rapport à toutes les unités constitutives formant le copolymère d'éthylène et d'ester insaturé (A) et une teneur (X₂) en unité constitutive dérivée d'éthylène par rapport à toutes les unités constitutives formant le copolymère à base d'éthylène contenant des groupes époxy (B) est inférieure ou égale à 10 % en masse.

2. Couche intermédiaire de verre feuilleté selon la revendication 1,
dans laquelle le copolymère d'éthylène et d'ester insaturé (A) comprend un copolymère d'éthylène et d'acétate de vinyle.

3. Couche intermédiaire de verre feuilleté selon la revendication 1 ou la revendication 2,
dans laquelle le copolymère à base d'éthylène contenant des groupes époxy (B) comprend au moins un type choisi dans le groupe constitué d'un copolymère d'éthylène et de(méth)acrylate de glycidyle, un copolymère d'éthylène et de(méth)acrylate de glycidyle et d'acétate de vinyle, et un copolymère d'éthylène et de (méth)acrylate de glycidyle et d'ester d'acide (méth)acrylique.

4. Couche intermédiaire de verre feuilleté selon l'une quelconque des revendications 1 à 3,
dans laquelle la teneur en unité constitutive dérivée d'éthylène dans le copolymère à base d'éthylène contenant des groupes époxy (B) est inférieure ou égale à 82 % en masse par rapport à toutes les unités constitutives formant le copolymère à base d'éthylène contenant des groupes époxy (B).

5. Couche intermédiaire de verre feuilleté selon l'une quelconque des revendications 1 à 4,
dans laquelle un trouble, mesuré selon le procédé suivant, est inférieur ou égal à 10 %,
(Procédé)
la composition de résine adhésive est pressée dans des conditions de 140 °C et 9,8 MPa et est ensuite refroidie dans des conditions de 20 °C et 14,7 MPa afin de préparer une feuille pressée d'une épaisseur de 3 mm, et
un trouble de la feuille pressée obtenue est ensuite mesuré à l'aide d'un appareil de mesure de trouble, conformément à JIS K 7136:2000.

6. Couche intermédiaire de verre feuilleté selon l'une quelconque des revendications 1 à 5,
dans laquelle, lorsqu'une teneur totale en copolymère d'éthylène et d'ester insaturé (A) et en copolymère à base d'éthylène contenant des groupes époxy (B) est représentée par 100 % en masse, une teneur en copolymère d'éthylène et d'ester insaturé (A) est de 40 % en masse ou plus et de 99 % en masse ou moins.

7. Couche intermédiaire de verre feuilleté selon l'une quelconque des revendications 1 à 6,
dans laquelle, lorsqu'une teneur totale en composition de résine adhésive est représentée par 100 % en masse, une teneur totale en copolymère d'éthylène et d'ester insaturé (A) et en copolymère à base d'éthylène contenant des groupes époxy (B) est de 70 % en masse ou plus et de 100 % en masse ou moins.

8. Couche intermédiaire de verre feuilleté selon l'une quelconque des revendications 1 à 7,
dans laquelle un trouble, mesuré selon le procédé suivant, est inférieur ou égal à 5 %,
(Procédé)
un verre d'une épaisseur de 3,2 mm, une couche de résine ionomère d'une épaisseur de 1 500 µm, une feuille d'une épaisseur de 100 µm formée à partir de la composition de résine adhésive, et un verre d'une épaisseur de 3,2 mm sont feuilletés dans cet ordre et sont liés à une température de chauffage de 140 °C et sous une pression de 1 atm pendant une durée de chauffage de 20 minutes,
le stratifié obtenu est refroidi lentement par refroidissement naturel afin de préparer un stratifié de verre destiné à l'évaluation de caractéristiques optiques, et
un trouble du verre feuilleté obtenu est ensuite mesuré à l'aide d'un appareil de mesure de trouble, conformément à JIS K 7136:2000.

9. Couche intermédiaire de verre feuilleté selon l'une quelconque des revendications 1 à 8,
dans laquelle toutes les forces d'adhérence sur un film de PET, mesurées à un stade initial, après 500 heures et après 1 000 heures selon le procédé suivant, sont égales ou supérieures à 15 N/15 mm,
(Procédé)
un verre d'une épaisseur de 3,9 mm (une surface non étamée est une surface adhésive), une feuille d'une épaisseur de 300 µm et formée à partir de la composition de résine adhésive, et un film de PET (sans traitement corona) d'une épaisseur de 100 µm sont feuilletés dans cet ordre et sont liés à une température de chauffage de 140 °C et sous une pression de 1 atm pendant une durée de chauffage de 60 minutes afin de préparer un stratifié de verre,
ensuite, le stratifié de verre est laissé au repos dans l'atmosphère et est lentement refroidi par refroidissement naturel,
une fente d'une largeur de 15 mm est formée dans une partie de feuille du stratifié de verre obtenu afin d'obtenir une éprouvette, et l'éprouvette est prévue dans une machine d'essai de traction,
un film de PET est décollé à un taux de traction de 100 mm/min et selon un angle de décollement de 180°, et une contrainte moyenne est obtenue comme force d'adhérence de stade initial (N/15 mm), et
le stratifié de verre est stocké dans des conditions de 85°C et d'une humidité relative de 90 % pour obtenir une force d'adhérence du stratifié de verre après le stockage pendant 500 heures et une force d'adhérence du stratifié de verre après le stockage pendant 1000 heures, respectivement.

10. Couche intermédiaire de verre feuilleté selon l'une quelconque des revendications 1 à 9,
dans laquelle la force d'adhérence à un film de PET, mesurée après le stockage pendant 1 000 heures selon le procédé suivant, est égal ou supérieur à 50 N/15 mm,
(Procédé)
un verre d'une épaisseur de 3,9 mm (une surface non étamée est une surface adhésive), une feuille d'une épaisseur de 300 µm et formée à partir de la composition de résine adhésive, et un film de PET (sans traitement corona) d'une épaisseur de 100 µm sont feuilletés dans cet ordre et sont liés à une température de chauffage de 140 °C et sous une pression de 1 atm pendant une durée de chauffage de 60 minutes afin de préparer un stratifié de verre,
ensuite, le stratifié de verre est laissé au repos dans l'atmosphère et est lentement refroidi par refroidissement naturel,
ensuite, le stratifié de verre est stocké dans des conditions de 85 °C et d'une humidité relative de 90 % pendant 1 000 heures,
une fente d'une largeur de 15 mm est formée dans une partie de feuille du stratifié de verre obtenu afin d'obtenir une éprouvette, et l'éprouvette est prévue dans une machine d'essai de traction, et
un film de PET est décollé à un taux de traction de 100 mm/min et selon un angle de décollement de 180°, et une contrainte moyenne est obtenue comme force d'adhérence (N/15 mm) au film de PET après le stockage de 1000 heures.

11. Couche intermédiaire de verre feuilleté selon l'une quelconque des revendications 1 à 10,
dans laquelle la couche de résine ionomère et la couche de résine adhésive sont adjacentes l'une à l'autre, et
la couche de résine de polyester est adjacente à une surface de la couche de résine adhésive qui est opposée à une surface adjacente à la couche de résine ionomère.

12. Verre feuilleté comprenant :
la couche intermédiaire de verre feuilleté selon l'une quelconque des revendications 1 à 11 ; et
un élément transparent de type de plaque qui est prévu sur les deux surfaces de la couche intermédiaire de verre feuilleté.

13. Verre feuilleté selon la revendication 12, comprenant :
au moins une configuration dans lequel l'élément de type de plaque transparente et la couche de résine ionomère sont adjacents l'un à l'autre.

14. Encapsulant de cellule photovoltaïque comprenant, dans l'ordre suivant :
une couche de résine ionomère comprenant un ionomère (C) constitué d'un copolymère à base d'éthylène et d'acide carboxylique insaturé ;
une couche de résine adhésive comprenant une composition de résine adhésive ; et
une couche de résine de polyester comprenant une résine de polyester (D),
la composition de résine adhésive comprenant :
un copolymère d'éthylène et d'ester insaturé (A) ; et
un copolymère à base d'éthylène contenant des groupes époxy (B) (autre que le copolymère d'éthylène et d'ester insaturé (A)),
dans lequel une teneur en unité constitutive dérivée d'un ester insaturé dans le copolymère d'éthylène et d'ester insaturé (A) est supérieure à 20 % en masse par rapport à toutes les unités constitutives formant le copolymère d'éthylène et d'ester insaturé (A), et
une valeur absolue d'une différence (X₁ - X₂) entre une teneur (X₁) en unité constitutive dérivée d'éthylène par rapport à toutes les unités constitutives formant le copolymère d'éthylène et d'ester insaturé (A) et une teneur (X₂) en unité constitutive dérivée d'éthylène par rapport à toutes les unités constitutives formant le copolymère à base d'éthylène contenant des groupes époxy (B) est inférieure ou égale à 10 % en masse.

15. Module de cellule photovoltaïque comprenant :
un élément de cellule photovoltaïque ; et
une couche de résine d'encapsulation formée à partir de l'encapsulant de cellule photovoltaïque selon la revendication 14 pour encapsuler l'élément de cellule photovoltaïque.
